(19) Europäisches Patentamt
European Patent Office
Office européen des brevets

(11) EP 2 905 144 B1

(12) EUROPEAN PATENT SPECIFICATION

(45) Date of publication and mention of the grant of the patent:
**19.07.2017 Bulletin 2017/29**

(21) Application number: **13841168.1**

(22) Date of filing: **30.08.2013**

(51) Int Cl.:
***B41C 1/10*** *(2006.01)* ***B41N 1/14*** *(2006.01)*
***G03F 7/00*** *(2006.01)* ***G03F 7/004*** *(2006.01)*
***G03F 7/029*** *(2006.01)* ***G03F 7/032*** *(2006.01)*
***G03F 7/11*** *(2006.01)*

(86) International application number:
**PCT/JP2013/073409**

(87) International publication number:
**WO 2014/050435 (03.04.2014 Gazette 2014/14)**

(54) **LITHOGRAPHIC PRINTING ORIGINAL PLATE AND PLATE MAKING METHOD**

ORIGINALFLACHDRUCKPLATTE UND PLATTENHERSTELLUNGSVERFAHREN

PLAQUE ORIGINALE D'IMPRESSION LITHOGRAPHIQUE ET PROCÉDÉ DE FABRICATION DE PLAQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.09.2012 JP 2012213070**

(43) Date of publication of application:
**12.08.2015 Bulletin 2015/33**

(73) Proprietor: **Fujifilm Corporation**
**Minato-ku**
**Tokyo 106-8620 (JP)**

(72) Inventor: **SUZUKI Shota**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A1- 1 431 032**
**JP-A- 2005 067 042**
**JP-A- 2008 200 891**
**JP-A- 2010 069 858**
**JP-A- 2010 234 589**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

TECHNICAL FIELD

The present invention relates to a lithographic printing plate precursor, and more particularly, to a lithographic printing plate precursor having a negative type recording layer, which enables compatibility between excellent printing durability and good tone reproducibility.

BACKGROUND ART

Development of laser in recent years is outstanding, in particular, in a solid laser and a semiconductor laser each having an emission region in a range from a near-infrared ray to an infrared ray, high power and miniaturization proceed. Thus, these lasers are very useful as an exposure light source at the time of direct plate making from digital data, for example, of a computer.

As the printing plate material used for a CTP system, for example, that comprising a film base material having provided thereon an image-recording layer of silver salt diffusion transfer system as disclosed in Patent Document 1, that comprising a film base material having provided thereon a hydrophilic layer and an oleophilic layer stacked in such a manner that any one of the hydrophilic layer and the oleophilic layer is stacked as a surface layer so as to form a printing plate by ablation of the surface layer with laser exposure as disclosed in Patent Document 2 or 3, that comprising a base material having provided thereon a hydrophilic layer and a heat fusible image-forming layer wherein heat is generated imagewise with lase exposure in the hydrophilic layer or the image-forming layer to fuse and fix the image-forming layer on the hydrophilic layer as disclosed in Patent Document 4, and that comprising a base material having provided thereon an image-recording layer containing a polymerizable compound are known.

As a negative type image-recording material, for example, a recording material composed of an infrared absorbing agent, an acid generator, and a cresol resin or a novolac resin is described in Patent Document 5. However, such a negative type image-recording material requires a heat treatment of approximately from 140 to 200°C for from 50 to 120 seconds after laser exposure in order to form an image and thus, a large-scale equipment and energy are needed for the heat treatment after exposure.

Also, a recording material comprising a cyanine dye having a specific structure, an iodonium salt, and an addition polymerizable compound having an ethylenically unsaturated double bond, which does not require the heat treatment after imagewise exposure is described in Patent Document 6. However, the image-recording material causes polymerization inhibition due to oxygen in the air at the polymerization reaction to result in problems of decrease in sensitivity and insufficient strength in the image area formed. On the other hand, in order to increase the sensitivity, a method of using as the initiator, a borate compound having a high donor property and a photopolymerization initiation ability itself and a method of using a sulfonium salt having a specific structure described in Patent Documents 7 and 8 are considered. According to the methods, however, there is a concern that the tone reproducibility degrades or that, for example, in the case of being handled under a white lamp, in the case of using a platesetter having a low extinction ratio, or in the case of preserving for a long period of time, an undesirable curing reaction proceeds so that the image-forming property degrades, for example, development defect due to the curing in the non-image area is apt to occur.

Further, in order to improve these problems, an attempt to prevent the degradation of the image-forming property by adding a polymerization inhibitor to the image-recording layer using an initiator of high sensitivity has been made. A heat mode accepting printing plate material using as a polymerization initiator, for example, a borate compound, a triazine compound or a specific onium salt, which does not require the heat treatment after exposure is known (for example, Patent Document 9 and Patent Document 10). In Patent Document 9, a negative lithographic printing plate capable of being recorded with an infrared ray having an image-recording layer containing (A) a borate or a triazine, (B) a polymerization inhibitor, (C) a light-heat converting agent, and (D) a polymerizable unsaturated group-containing compound is disclosed.

On the other hand, by the addition of the polymerization inhibitor, sensitivity and printing durability decrease, although the undesirable curing reaction is suppressed so that the degradation of tone reproducibility, development defect and the like can be prevented. Patent Document 11 describes a Polymerizable composition in a negative type lithographic printing plate precursor whereby the plate can be directly made using infrared laser beams.

PRIOR ART DOCUMENT

PATENT DOCUMENT

Patent Document 1: JP-A-5-66564
Patent Document 2: JP-A-8-507727
Patent Document 3: JP-A-10-58636
Patent Document 4: JP-A-2001-96710
Patent Document 5: U.S. Patent 5,340,699
Patent Document 6: JP-B-7-103171
Patent Document 7: JP-A-2005-67042
Patent Document 8: JP-A-2009-25837
Patent Document 9: JP-A-2002-107916
Patent Document 10: JP-A-2003-76010
Patent Document 11: EP-A1-1-431-032

DISCLOSURE OF THE INVENTION

PROBLEMS THAT THE INVENTION IS TO SOLVE

An object of the present invention is to provide a lithographic printing plate precursor which is capable of being directly recorded from digital data, for example, of a computer, which has high sensitivity, and which can form an image having a high image quality by preventing an undesirable curing reaction in the non-image area from proceeding, wherein the lithographic printing plate precursor can provide a lithographic printing plate having high printing durability, and a plate making method using the same.

MEANS FOR SOLVING THE PROBLEMS

Specifically, the means for solving the problems described above are as follows. In the specification, the range represented by using "to" indicates a range including the numerical values described before and after "to" as the minimum value and the maximum value, respectively.

(1) A lithographic printing plate precursor comprising a support having provided thereon an image-recording layer containing (A) an infrared absorbing agent, (B) a sulfonium salt, (C) a polymerizable compound, and (D) a binder polymer, wherein the sulfonium salt (B) has a triarylsulfonium structure having three or more electron-withdrawing groups as substituents, and at least one aryl group constituting the triarylsulfonium structure has at least one of the electron-withdrawing groups and at least one group selected from the group consisting of a hydrocarbon group having from 4 to 12 carbon atoms, a group wherein a hydrocarbon group having from 4 to 12 carbon atoms is connected to an oxygen atom or a sulfur atom, and an ethylene oxide group having a repeating unit number of from 1 to 3.
(2) The lithographic printing plate precursor as described in (1) above, wherein the at least one aryl group constituting the triarylsulfonium structure of the sulfonium salt (B) has at least one of the electron-withdrawing groups and at least one group of a hydrocarbon group having from 4 to 12 carbon atoms and a group wherein a hydrocarbon group having from 4 to 12 carbon atoms is connected to an oxygen atom.
(3) The lithographic printing plate precursor as described in (2) above, wherein the electron-withdrawing group substituted on the aryl group together with the at least one group of a hydrocarbon group having from 4 to 12 carbon atoms and a group wherein a hydrocarbon group having from 4 to 12 carbon atoms is connected to an oxygen atom is a group selected from the group consisting of a chlorine atom, a fluorine atom and a trifluoromethyl group.
(4) The lithographic printing plate precursor as described in any one of (1) to (3) above, wherein the binder polymer (D) has an alkylene oxide group.
(5) The lithographic printing plate precursor as described in any one of (1) to (4) above, wherein the image-recording layer further contains a borate compound.
(6) The lithographic printing plate precursor as described in (5) above, wherein the borate compound is a tetraphenylborate salt.
(7) The lithographic printing plate precursor as described in any one of (1) to (6) above, which has a protective layer on the image-recording layer.
(8) The lithographic printing plate precursor as described in (7) above, wherein the protective layer contains an inorganic stratiform compound.
(9) The lithographic printing plate precursor of on-press development type as described in any one of (1) to (8) above, wherein the image-recording layer contains a binder polymer for on-press development and wherein an unexposed area of the image-recording layer is capable of being removed with at least one of dampening water and printing ink.

(10) A plate making method comprising exposing imagewise the lithographic printing plate precursor of on-press development type as described in (9) above by an infrared laser, mounting the exposed lithographic printing plate precursor on a cylinder of printing machine, and removing the unexposed area of the image-recording layer with at least one of dampening water and printing ink.

The mechanism of the invention is not clear, but it is supposed as follows.

Since at least one aryl group constituting the triarylsulfonium salt having three or more electron-withdrawing groups as substituents has both an electron-withdrawing group and a substituent having a specific structure described later, in case of laser exposure, the radical generation amount increases by the effect of the electron-withdrawing group and the mobility of the radical generated is suitably suppressed by the effect of the substituent having a specific structure, whereby the radical does not diffuse more than necessary. It is supposed that, as a result, in the portion which is irradiated with a weak laser beam so as not to want to form an image, that is, in the portion where the radical amount is small, the polymerization is suppressed to prevent the undesirable film curing and at the same time, in the portion which is irradiated with a strong laser beam so as to want to form an image, that is, in the portion where the radical amount is large, the polymerization is accelerated to achieve high printing durability.

ADVANTAGE OF THE INVENTION

According to the invention, a lithographic printing plate precursor which is capable of being directly recorded from digital data, for example, of a computer, which has high sensitivity, which prevents an undesirable curing reaction in the non-image area from proceeding, and which provides high printing durability can be obtained.

MODE FOR CARRYING OUT THE INVENTION

The lithographic printing plate precursor according to the invention is a lithographic printing plate precursor comprising a support having provided thereon an image-recording layer containing (A) an infrared absorbing agent, (B) a sulfonium salt, (C) a polymerizable compound, and (D) a binder polymer, wherein the sulfonium salt (B) has a triarylsulfonium structure having three or more electron-withdrawing groups as substituents, and at least one aryl group constituting the triarylsulfonium structure has at least one of the electron-withdrawing groups and at least one group selected from the group consisting of a hydrocarbon group having from 4 to 12 carbon atoms, a group wherein a hydrocarbon group having from 4 to 12 carbon atoms is connected to an oxygen atom or a sulfur atom, and an ethylene oxide group having a repeating unit number from 1 to 3.

[Lithographic printing plate precursor]

The lithographic printing plate precursor according to the invention comprises a support having provided thereon an image-recording layer containing components (A) to (D) described above. The lithographic printing plate precursor according to the invention can be provided with an undercoat layer between the support and the image-recording layer or a protective layer on the image-recording layer, if desired.

Hereinafter, the constituting components of the lithographic printing plate precursor according to the invention will be described.

[Image-recording layer]

The image-recording layer according to the invention is characterized by containing (A) an infrared absorbing agent, (B) a sulfonium salt, (C) a polymerizable compound, and (D) a binder polymer.

[(A) Infrared absorbing agent]

The infrared absorbing agent used in the polymerizable composition can be used without particular restriction as long as it absorbs light at the image exposure to form the excited state and provides energy to a polymerization initiator with electron transfer, energy transfer, heat generation or the like thereby increasing the polymerization initiation function. Particularly, an infrared absorbing agent having an absorption maximum in a wavelength range from 750 to 1,400 nm is preferably used. The infrared absorbing agent used is preferably a dye or a pigment.

As the dye, commercially available dyes and known dyes described in literatures, for example, Senryo Binran, compiled by The Society of Synthetic Organic Chemistry, Japan (1970) can be used. Specifically, the dye includes, for example, an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium

salt and a metal thiolate complex.

Of the dyes, a cyanine dye, a squarylium dye, a pyrylium salt, a nickel thiolate complex or an indolenine cyanine dye is particularly preferred. A cyanine dye or an indolenine cyanine dye is more preferred. As a particularly preferred example of the dye, a cyanine dye represented by formula (IV) shown below is exemplified.

Formula (IV)

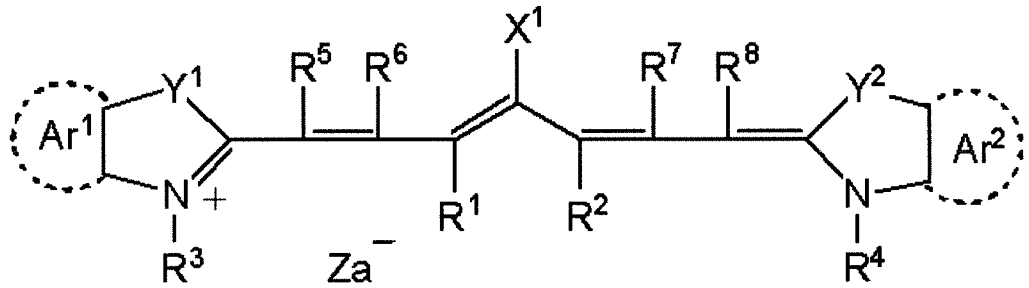

In formula (IV), $X^1$ represents a hydrogen atom, a halogen atom, $-N(R^9)(R^{10})$, $-X^2-L^1$ or a group shown below. $R^9$ and $R^{10}$, which may be the same or different, each represents an aromatic hydrocarbon group having from 6 to 10 carbon atoms which may have a substituent, an alkyl group having from 1 to 8 carbon atoms which may have a substituent or a hydrogen atom, or $R^9$ and $R^{10}$ may be combined with each other to form a ring. $R^9$ and $R^{10}$ each preferably represents a phenyl group. $X^2$ represents an oxygen atom or a sulfur atom. $L^1$ represents a hydrocarbon group having from 1 to 12 carbon atoms, an aromatic ring group containing a hetero atom (N, S, O, a halogen atom, Se) or a hydrocarbon group having from 1 to 12 carbon atoms and containing a hetero atom. In the group shown below, $Xa^-$ has the same meaning as $Za^-$ defined hereinafter. $R^a$ represents a hydrogen atom or a substituent selected from an alkyl group, an aryl group, a substituted or unsubstituted amino group and a halogen atom.

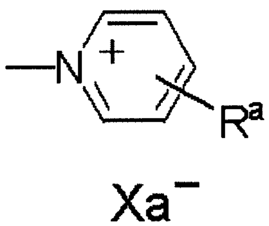

$R^1$ and $R^2$ in formula (IV) each independently represents a hydrocarbon group having from 1 to 12 carbon atoms. In view of the preservation stability of a polymerizable composition solution, it is preferred that $R^1$ and $R^2$ each represents a hydrocarbon group having two or more carbon atoms. Alternatively, $R^1$ and $R^2$ may be combined with each other to form a ring and in the case of forming a ring, it is particularly preferred to form a 5-membered ring or a 6-membered ring.

$Ar^1$ and $Ar^2$, which may be the same or different, each represents an aryl group which may have a substituent. Preferred examples of the aryl group include a benzene ring group and a naphthalene ring group. Preferred examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms which may have a substituent. Preferred examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (IV) has an anionic substituent in the structure thereof and neutralization of charge is not needed. Preferred examples of the counter ion for $Za^-$ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion in view of the preservation stability of a polymerizable composition solution.

Specific examples of the cyanine dye represented by formula (IV) include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of JP-A-2008-195018, and particularly preferably compounds described in Paragraph Nos. [0035] to [0043] of JP-A-2007-90850.

Also, compounds described in Paragraph Nos. [0008] to [0009] of JP-A-5-5005 and Paragraph Nos. [0022] to [0025] of JP-A-2001-222101 are preferably used.

Preferred specific examples of the infrared absorbing agent are set forth below, bur the invention should not be construed as being limited thereto.

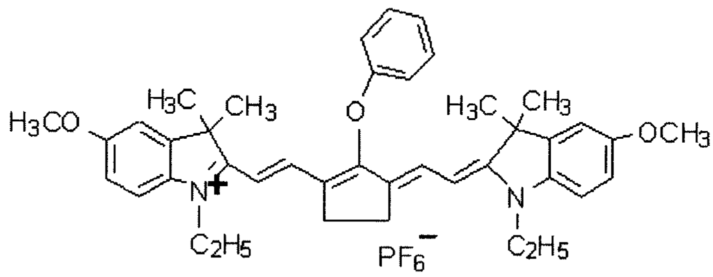

IR−1

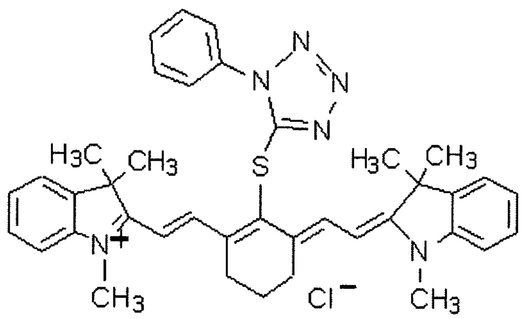

IR−2

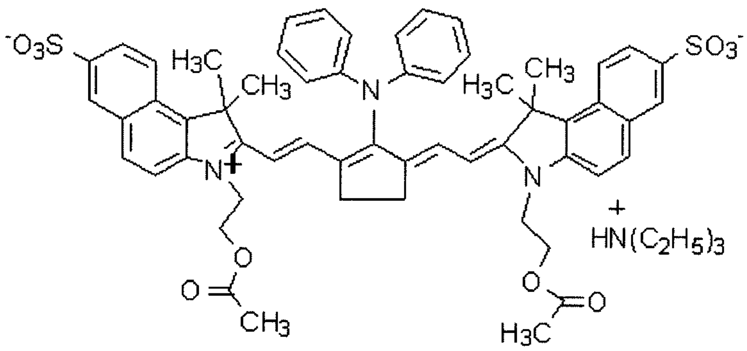

IR−3

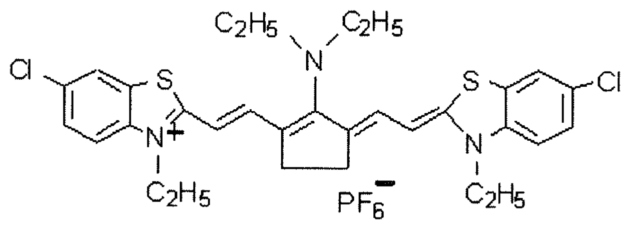

IR−4

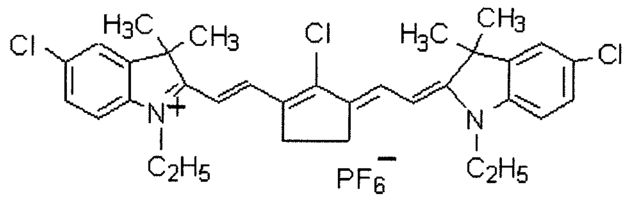

IR－5

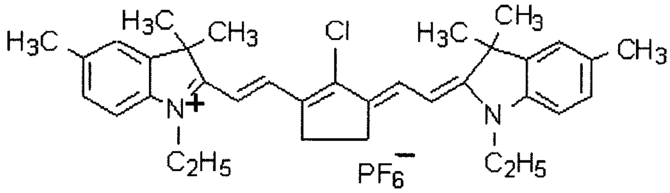

IR－6

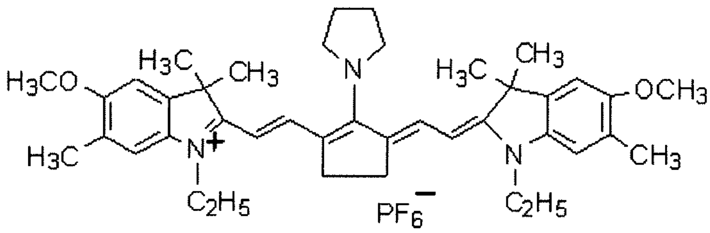

IR－7

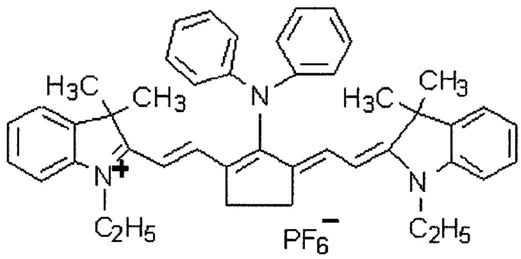

IR－8

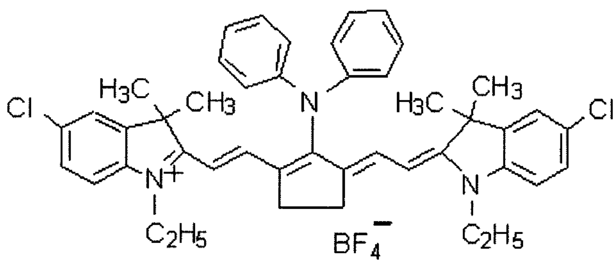

IR－9

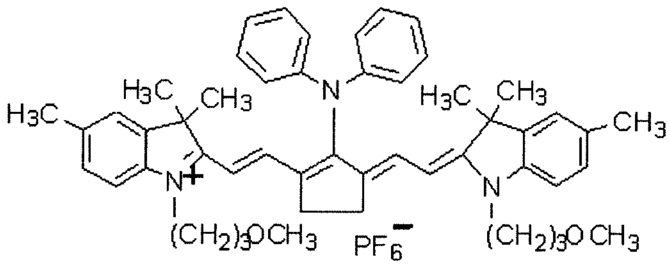

IR−10

The infrared absorbing agent may be used only one kind or in combination of two or more kinds thereof, and it may also be used together with an infrared absorbing agent, for example, a pigment. As the pigment, compounds described in Paragraph Nos. [0072] to [0076] of JP-A-2008-195018 are preferred.

The content of the infrared absorbing agent is preferably from 0.05 to 30% by weight, more preferably from 0.1 to 20% by weight, particularly preferably from 0.2 to 10% by weight, based on 100 parts by weight of the total solid content of the image-recording layer.

[(B) Sulfonium salt]

The sulfonium salt (B) for use in the invention denotes a sulfonium salt which has a triarylsulfonium structure having three or more electron-withdrawing groups as substituents, and at least one aryl group constituting the triarylsulfonium structure has at least one electron-withdrawing group and at least one group selected from the group consisting of a hydrocarbon group having from 4 to 12 carbon atoms, a group wherein a hydrocarbon group having from 4 to 12 carbon atoms is connected to an oxygen atom or a sulfur atom, and an ethylene oxide group having a repeating unit number from 1 to 3.

The triarylsulfonium salt according to the invention is a salt constituted from a monovalent cation having a molecular structure (triarylsulfonium structure) wherein three aryl groups are connected to a sulfur atom and a counter anion. It is known that a triarylsulfonium salt functions as a polymerization initiator (for example, J. Amer. Chem. Soc., Vol. 112(60), pp. 6004-6015 (1990) or Japanese Patent No. 4,426,795), and it functions as a compound which initiates or accelerates polymerization of polymerizable compound (C) in the invention.

The three aryl groups constituting the triarylsulfonium structure may be different from each other or two or three aryl groups may be the same, and it is preferred that three aryl groups are the same. The aryl group is preferably a phenyl group or a naphthyl group, and more preferably a phenyl group.

The electron-withdrawing group according to the invention includes a halogen atom, a halogenated alkyl group, an acyl group, an acyloxy group, an alkanesulfinyl group, a cyano group, a nitro group, an amido group, a carboxyl group and a carboxylic acid ester group. The halogen atom includes a fluorine atom, a chlorine atom, a bromine atom and an iodine atom. The halogenated alkyl group includes a trifluoromethyl group. The acyl group includes an acetyl group and a formyl group. The alkanesulfinyl group includes a methanesulfinyl group. The amido group includes an acetamido group. The carboxylic acid ester group includes a carboxylic acid alkyl ester group and a carboxylic acid phenyl ester group, and a number of carbon atoms in the alkyl group is from 1 to 8. From the standpoint of radical generation amount, the electron-withdrawing group is preferably a halogen atom or a halogenated alkyl group, more preferably a fluorine atom, a chlorine atom or a trifluoromethyl group, and most preferably a chlorine atom.

A number of the electron-withdrawing groups in one aryl group having at least one electron-withdrawing group and at least one group selected from the group consisting of a hydrocarbon group having from 4 to 12 carbon atoms, a group wherein a hydrocarbon group having from 4 to 12 carbon atoms is connected to an oxygen atom or a sulfur atom, and an ethylene oxide group having a repeating unit number from 1 to 3 is more preferably 2. The total number of the electron-withdrawing groups substituted on the three aryl groups constituting the triarylsulfonium structure is in a range from 3 to 6 wherein the larger number is preferred from the standpoint of mobility of radical and radical generation amount.

At least one aryl group constituting the triarylsulfonium structure has at least electron-withdrawing group and at least one group selected from the group consisting of a hydrocarbon group having from 4 to 12 carbon atoms, a group wherein a hydrocarbon group having from 4 to 12 carbon atoms is connected to an oxygen atom or a sulfur atom, and an ethylene oxide group having a repeating unit number from 1 to 3 (hereinafter, the at least one aryl group is also referred to as a "specific aryl group") from the standpoint of mobility of radical as described above.

More specifically, when a number of carbon atoms in the hydrocarbon group is in a range from 4 to 12 or when a repeating unit number of the ethylene oxide group is in a range from 1 to 3, a suitable radical diffusivity is obtained for

achieving the compatibility between the printing durability and the tone reproducibility. Specifically, depending on the bulkiness of the group, the diffusivity of the radical generated changes. It is supposed that the compatibility between the printing durability and the tone reproducibility can be achieved by bringing a balance between the encounter frequency of the radical with a polymerizable compound due to diffusion of the radical and the nondiffusion of the radical into the non-image area (unexposed area) where the radical does not generate.

As the hydrocarbon group having from 4 to 12 carbon atoms in the hydrocarbon group having from 4 to 12 carbon atoms and the group wherein a hydrocarbon group having from 4 to 12 carbon atoms is connected to an oxygen atom or a sulfur atom, a straight-chain hydrocarbon group, a branched hydrocarbon group, a non-aromatic cyclic hydrocarbon group, a group formed by combining a straight-chain or branched hydrocarbon group with a non-aromatic cyclic hydrocarbon group, a hydrocarbon group having an aromatic ring and a hydrocarbon group having a hetero ring are exemplified.

The hydrocarbon group having from 4 to 12 carbon atoms is preferably a straight-chain hydrocarbon group, a branched hydrocarbon group, a non-aromatic cyclic hydrocarbon group or a group formed by combining a straight-chain or branched hydrocarbon group with a non-aromatic cyclic hydrocarbon group, and more preferably a straight-chain or branched hydrocarbon group.

As the straight-chain hydrocarbon group having from 4 to 12 carbon atoms, a n-butyl group, a n-pentyl group, a n-hexyl group, a n-heptyl group, a n-octyl group, a n-nonyl group, a n-decyl group, a n-undecyl group and a n-dodecyl group are exemplified.

As the branched hydrocarbon group having from 4 to 12 carbon atoms, for example, an isobutyl group, a tert-butyl group, an isopentyl group, a neopentyl group, an isohexyl group and a 2-ethylhexyl group are exemplified.

As the non-aromatic cyclic hydrocarbon group having from 4 to 12 carbon atoms, for example, a cyclopentyl group and a cyclohexyl group are exemplified.

As the group formed by combining a straight-chain or branched hydrocarbon group with a non-aromatic cyclic hydrocarbon group having from 4 to 12 carbon atoms, for example, a 2-cyclohexylethyl group is exemplified.

As the hydrocarbon group having an aromatic ring and having from 4 to 12 carbon atoms, for example, a phenyl group, a benzyl group and a phenethyl group are exemplified.

As the hydrocarbon group having a hetero ring and having from 4 to 12 carbon atoms, for example, a thienyl group and a thienylmethyl group are exemplified.

The specific aryl group preferably has at least one electron-withdrawing group and at least any of a hydrocarbon group having from 4 to 12 carbon atoms and a group wherein a hydrocarbon group having from 4 to 12 carbon atoms is connected to an oxygen atom, particularly preferably at least one electron-withdrawing group and a group wherein a straight-chain or branched hydrocarbon group having from 4 to 12 carbon atoms is connected to an oxygen atom, and most preferably at least one electron-withdrawing group and a group wherein a straight-chain or branched hydrocarbon group having from 6 to 10 carbon atoms is connected to an oxygen atom.

Further, the specific aryl group preferably has any of a fluorine atom, a chlorine atom and a trifluoromethyl group, as the electron-withdrawing group and at least any of a hydrocarbon group having from 4 to 12 carbon atoms and a group wherein a hydrocarbon group having from 4 to 12 carbon atoms is connected to an oxygen atom.

Preferred specific examples of the sulfonium salt (B) are set forth below, but the invention should not be construed as being limited thereto.

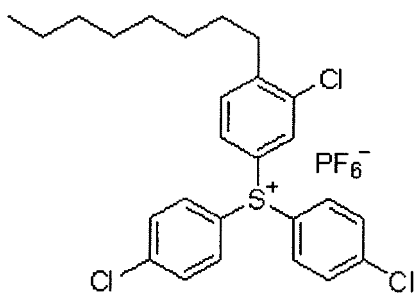

S-1

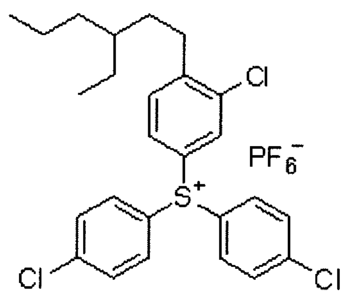

S-2

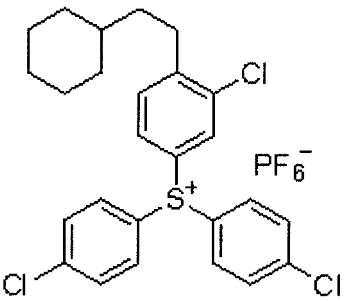

S-3

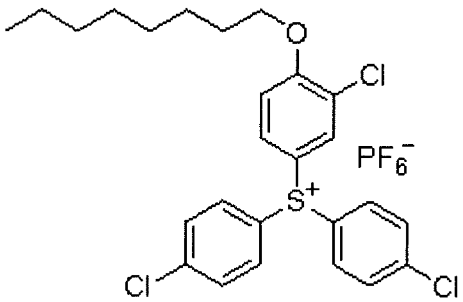

S-4

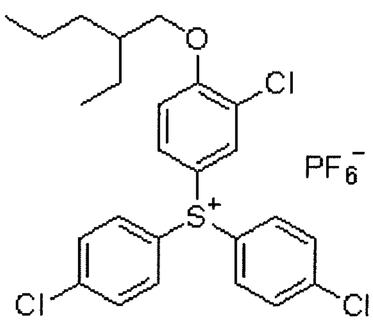

S-5

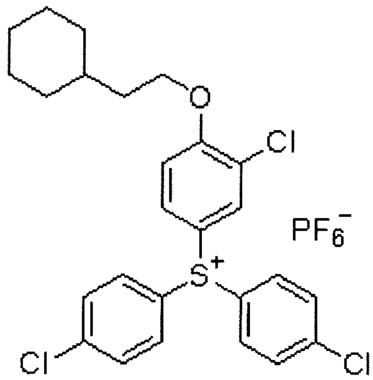

S-6

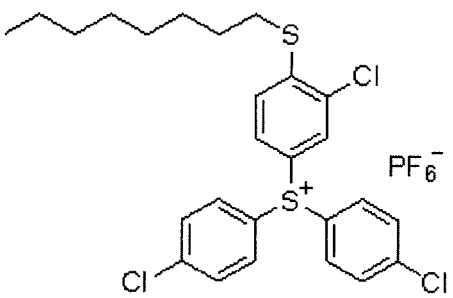

S-7

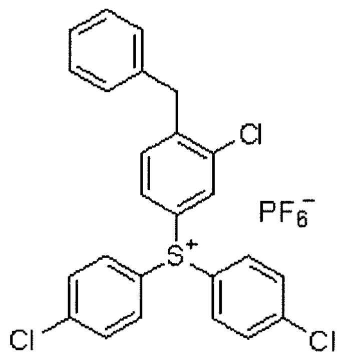

S-8

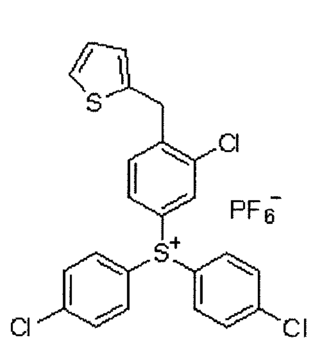

S-9

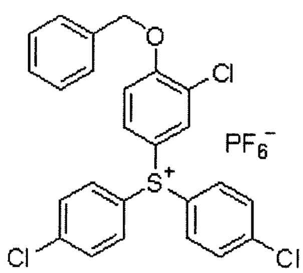

S-10

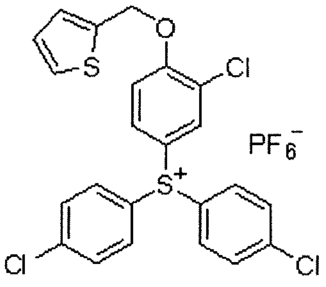

S-11

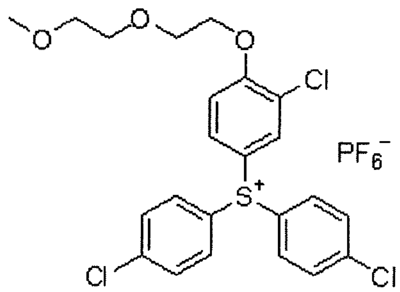

S-12

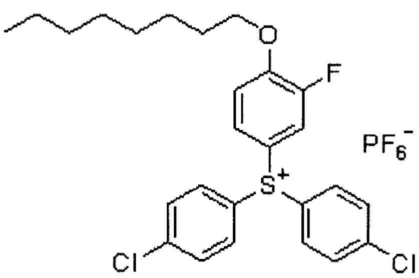

S-13

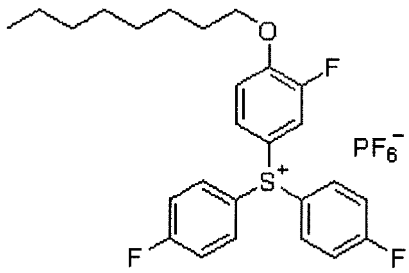

S-14

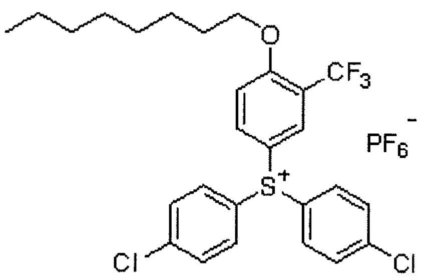

S-15

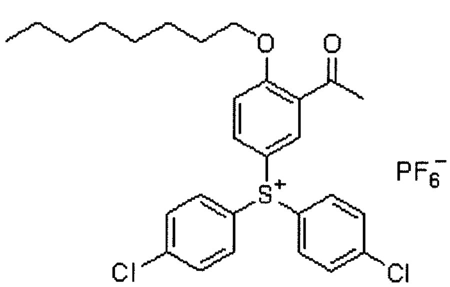

S-16

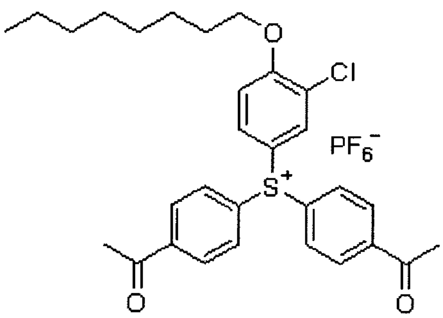

S-17

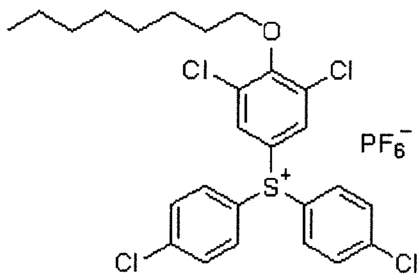

S-18

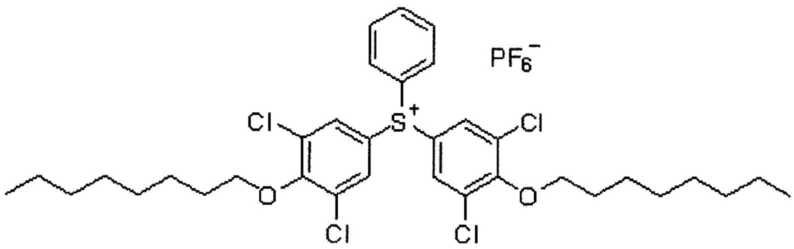

S-19

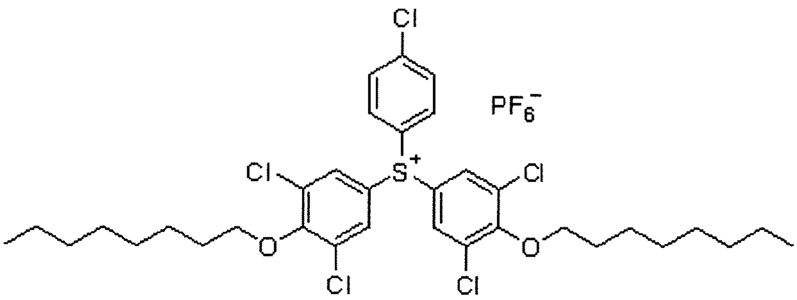

S-20

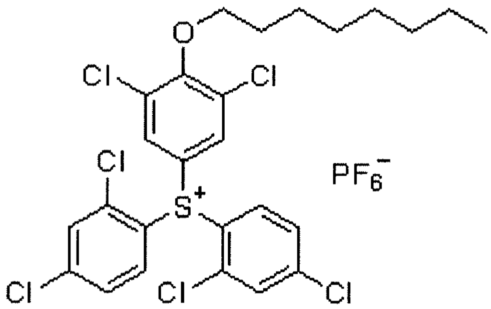

S-21

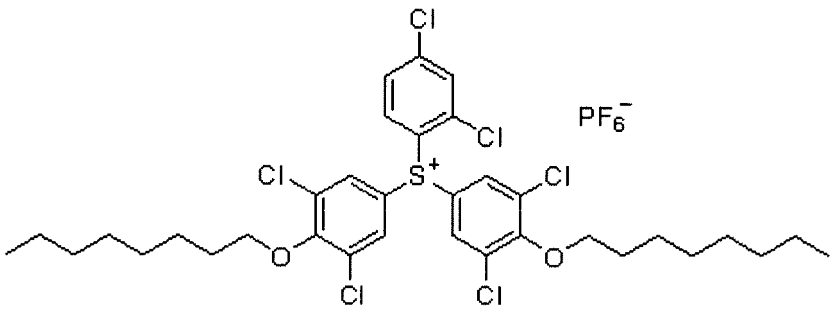

S-22

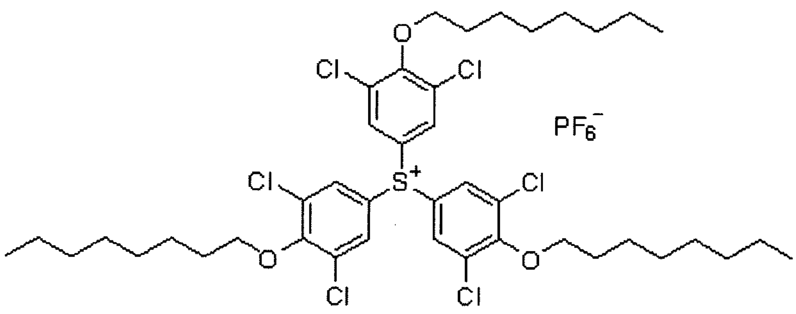

S-23

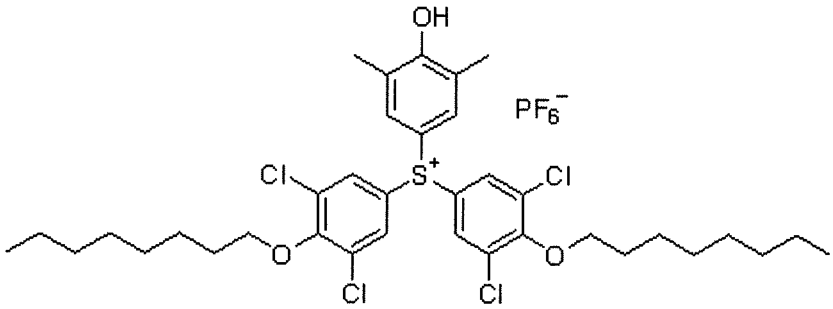

S-24

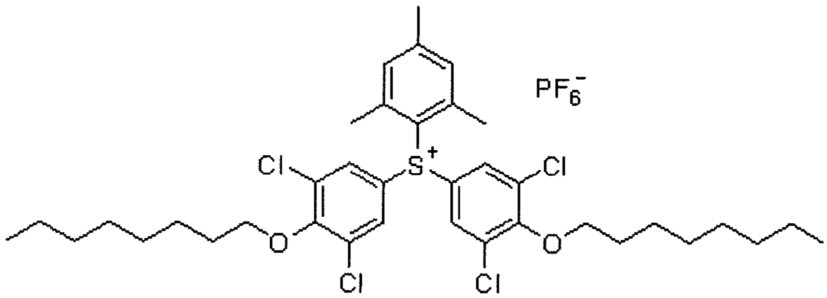

S-25

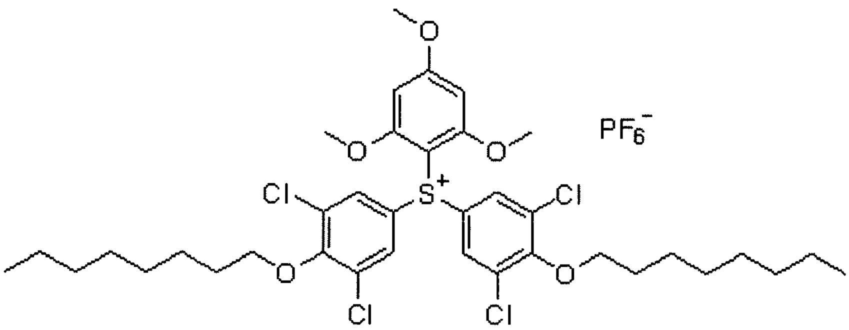

S-26

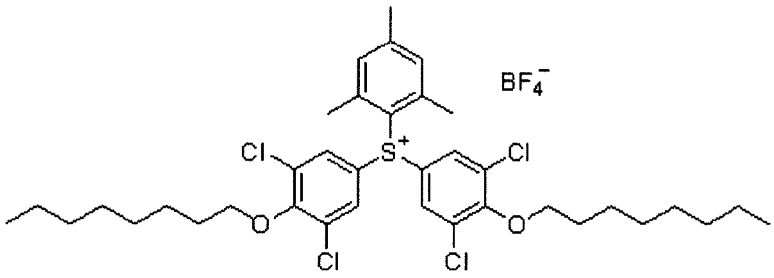

S-27

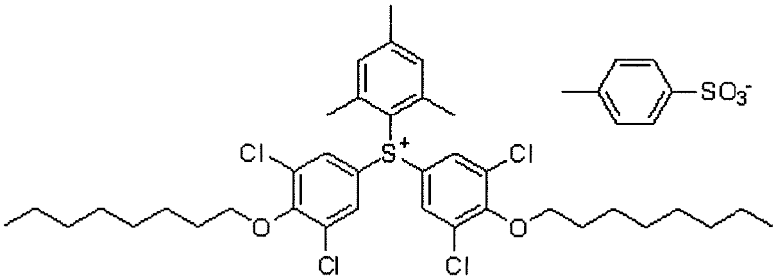

S-28

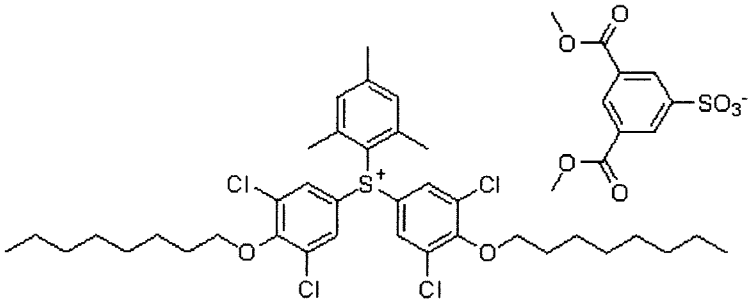

S-29

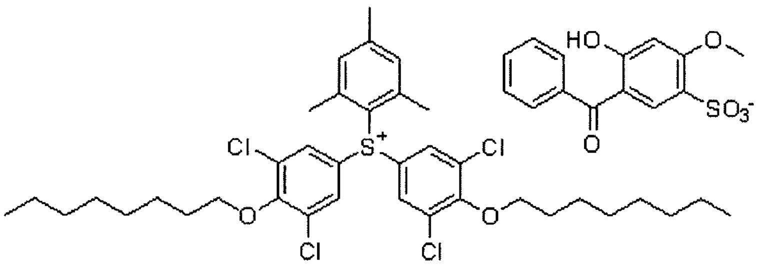

S-30

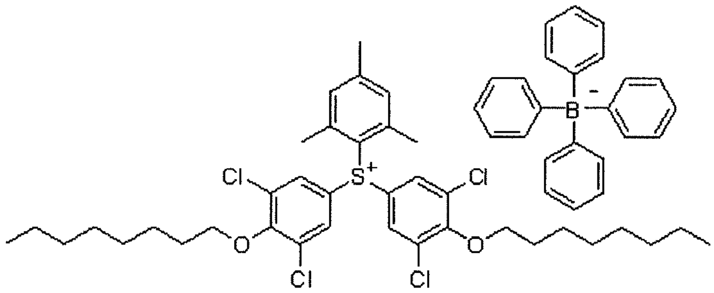

S-31

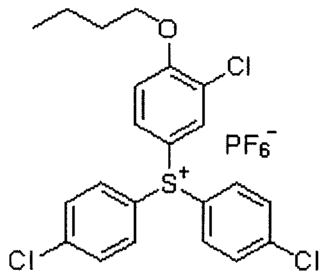

S-32

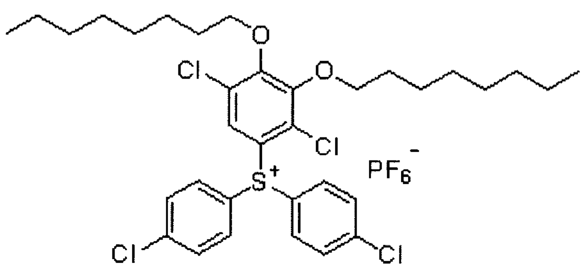

S-33

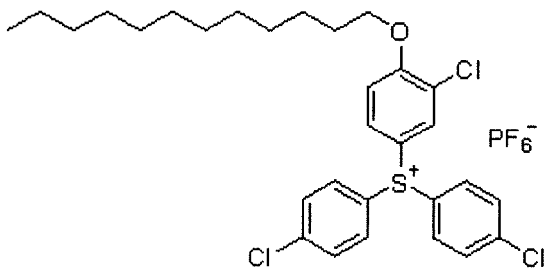

S-34

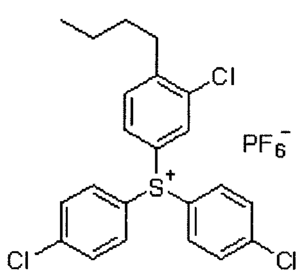

S-35

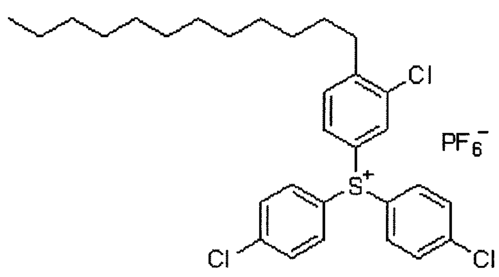

S-36

The sulfonium salt (B) can be added preferably in an amount from 0.1 to 50% by weight, more preferably from 0.5 to 30% by weight, particularly preferably from 0.8 to 20% by weight, based on the total solid content constituting the image-recording layer. In the range described above, good sensitivity, printing durability, good tone reproducibility and development property are obtained. The sulfonium salt (B) may be used only one kind or may be used in combination of two or more kinds thereof.

In the case of using the sulfonium salt (B) in combination with other polymerization initiator, as the other polymerization initiator, for example, (a) an organic halide, (b) a carbonyl compound, (c) an azo compound, (d) an organic peroxide, (e) a metallocene compound, (f) an azide compound, (g) a hexaarylbiimidazole compound, (h) a borate compound, (i) a disulfone compound, (j) an oxime ester compound and (k) an onium salt compound can be used.

As the organic halide (a), compounds described in Paragraph Nos. [0022] to [0023] of JP-A-2008-195018 are preferred.

As the carbonyl compound (b), compounds described in Paragraph No. [0024] of JP-A-2008-195018 are preferred.

As the azo compound (c), for example, azo compounds described in JP-A-8-108621 can be used.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azide compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the borate compound (h), for example, compounds described in Paragraph No. [0028] of JP-A-2008-195018 are preferred.

As the disulfone compound (i), for example, compounds described in JP-A-61-166544 and JP-A-2002-328465 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S. I. Schlesinger, Photogr. Sci. Eng., 18, 387 (1974), T. S. Bal et al., Polymer, 21, 423 (1980) and JP-A-5-158230, ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848, JP-A-2008-195018 and J. V. Crivello et al., Macromolecules, 10 (6), 1307 (1977), sulfonium salts described in European Patents 370,693, 233,567, 297,443 and 297,442, U.S. Patents 4,933,377, 4,760,013, 4,734,444 and 2,833,827 and German Patents 2,904,626, 3,604,580 and 3,604,581, selenonium salts described in J. V. Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.

Of the compounds described above, an iodonium salt and a borate compound are preferably exemplified. Specific examples of these compounds are set forth below, but the invention should not be construed as being limited thereto.

As examples of the iodonium salt, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium tetraphenylborate.

As specific examples of the borate compound, a tetraphenylborate salt, a tetratolylborate salt, a tetrakis(4-methoxyphenyl)borate salt, a tetrakis(pentafluorophenyl)borate salt, a tetrakis(3,5-bis(trifluoromethyl)phenyl)borate salt, a tetrakis(4-chlorophenyl)borate salt, a tetrakis(4-fluorophenyl)borate salt, a tetrakis(2-thienyl)borate salt, a tetrakis(4-phenylphenyl)borate salt, a tetrakis(4-tert-butylphenyl)borate salt, an ethyltriphenylborate salt and a butyltriphenylborate salt are exemplified. From the standpoint of achieving the compatibility between the printing durability and the tone reproducibility, a tetraphenylborate salt is preferred. As a counter cation of the borate salt, a known cation, for example, an alkali metal cation, an alkaline earth metal cation, an ammonium cation, a phosphonium cation, a sulfonium cation, an iodonium cation, a diazonium cation or an azinium cation is exemplified.

[(C) Polymerizable compound]

The polymerizable compound for use in the image-recording layer according to the invention is not particularly limited. Of the polymerizable compounds, a polymerizable compound having at least one ethylenically unsaturated double bond is preferred, a polymerizable compound having at least one terminal ethylenically unsaturated double bond is more preferred, and a polymerizable compound having at least two terminal ethylenically unsaturated double bonds is particularly preferred. The preferred polymerizable compound has a chemical form, for example, a monomer, a prepolymer, specifically, a dimer, a trimer or an oligomer, or a mixture thereof.

Examples of the monomer include an unsaturated carboxylic acid (for example, acrylic acid, methacrylic acid, itaconic acid, crotonic acid, isocrotonic acid or maleic acid) and an ester or amide thereof Preferably, an ester of an unsaturated carboxylic acid with a polyhydric alcohol compound and an amide of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of an unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. These compounds are described in references including JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule described in JP-B-48-41708.

$$CH_2{=}C(R^4)COOCH_2CH(R^5)OH \qquad (A)$$

wherein $R^4$ and $R^5$ each independently represents H or $CH_3$.

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, an isocyanuric acid ethyleneoxide-modified acrylate, for example, tris(acryloyloxyethyl) isocyanurate or bis(acryloyloxyethyl) hydroxyethyl isocyanurate is particularly preferred from the standpoint of excellent balance between hydrophilicity relating to the on-press development property and polymerization ability relating to the printing durability.

Details of the method of using the polymerizable compound, for example, the structure, the type of usage (for example, individual use or combination use of two or more kinds) or the addition amount can be appropriately determined in accordance with the characteristic design of the final lithographic printing plate precursor. The polymerizable compound is used preferably in a range from 5 to 75% by weight, more preferably in a range from 10 to 70% by weight, particularly preferably in a range from 14 to 60% by weight, based on the total solid content of the image-recording layer.

[(D) Binder polymer]

The image-recording layer according to the invention ordinarily contains a binder polymer in order to impart a film-forming property. As the binder polymer which can be used in the invention, heretofore known binder polymers can be used without limitation as long as it can impart the film-forming property. It may be a straight-chain binder polymer or a star-like polymer as described in JP-A-2007-249036. For example, an addition polymer and a urethane resin having a crosslinkable group in its side chain described below for the lithographic printing plate precursor are preferably exemplified.
The binder polymer can be incorporated into the image-recording layer in an arbitrary amount, and the content of the binder polymer in the image-recording layer is preferably from 10 to 90% by weight, more preferably from 15 to 80% by weight, based on the total solid content constituting the image-recording layer.
In the image-recording layer of the lithographic printing plate precursor according to the invention, it is preferred to use the binder polymer depending on a development method.

(D1) Binder polymer for alkali development

Although the chemical structure of the binder polymer is not particularly limited, from the standpoint of solubility in an alkaline processing solution, that is, development property, an organic polymer having an acid group is preferred and particularly, an organic polymer having a carboxylic acid or a salt thereof is more preferred.
As the binder polymer which can be used in the image-recording layer for lithographic printing plate precursor of alkali development type, an aqueous alkali soluble or swellable organic polymer having a carboxylic acid is exemplified. Useful examples of such an organic polymer include addition polymers having a carboxylic acid group in their side chains, for example, polymers described in JP-B-59-44615, JP-B-54-34327, JP-B-58-12577, JP-B-54-25957, JP-A-54-92723, JP-A-59-53836 and JP-A-59-71048, specifically, methacrylic acid copolymers, acrylic acid copolymers, itaconic acid copolymers, crotonic acid copolymers, maleic acid copolymers and partially esterified maleic acid copolymers. As the binder polymer, a copolymer containing a monomer unit derived from a (meth)acrylate and having a carboxylic acid (salt) group is preferred.
Also, an acidic cellulose derivative having a carboxylic acid group in its side chain and a product obtained by adding a cyclic acid anhydride to an addition polymer having a hydroxy group are useful. Further, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful as the aqueous alkali soluble or swellable binder. As the binder polymer for use in the invention, an acrylic resin, a methacrylic resin or a urethane resin is preferably employed.
One preferred example of material for the binder polymer for alkali development is a copolymer having (a) a monomer unit having a carboxylic acid group (including its salt) and (b) a monomer unit for imparting a radical crosslinking property.
The monomer unit (a) having a carboxylic acid group is not particularly limited and structures described in JP-A-2002-40652 and Paragraph Nos. [0059] to [0075] of JP-A-2005-300650 are preferably used.
The monomer unit (b) for imparting a radical crosslinking property is not particularly limited and structures described in Paragraph Nos. [0041] to [0053] of JP-A-2007-248863 are preferably used.
The binder polymer for alkali development may contain a monomer unit derived from an ethylenically unsaturated compound which contains neither the monomer unit (a) having a carboxylic acid group nor the monomer unit (b) for imparting a radical crosslinking property as a copolymerization component.
As such a monomer unit, a monomer unit derived from a (meth)acrylate or (meth)acrylamide is preferred. Particularly, a monomer unit derived from amido group (meth)acrylamide described in Paragraph Nos. [0061] to [0084] of JP-A-2007-272134 is preferably used. The content of such a monomer unit is preferably from 5 to 50 units, more preferably from 5 to 35 units, still more preferably from 5 to 25 units, when the total number of monomer units is taken as 100.
In the image-recording layer of the lithographic printing plate precursor according to the invention, in addition to the addition polymer containing a combination of the monomer units described above, a urethane resin having a crosslinkable group in its side chain can also be used as the binder polymer. The term "crosslinkable group" as used herein means a group capable of crosslinking the binder polymer upon a chemical reaction which is caused in the image-recording layer, when the lithographic printing plate precursor is exposed to light. A chemical structure of the crosslinkable group is not particularly limited as long as the crosslinkable group has such a function and, for example, an ethylenically unsaturated group is preferred as a functional group capable of undergoing an addition polymerization reaction. Also, functional groups described in Paragraph Nos. [0130] to [0139] of JP-A-2007-17948 are exemplified.
The polyurethane resin having a crosslinkable group in its side chain particularly preferably used in the invention can be obtained by a polyaddition reaction of (i) a diisocyanate compound, (ii) a diol compound having a carboxyl group, (iii) a diisocyanate compound having a crosslinkable group and, if desired, (iv) a diol compound containing no carboxyl

group and (v) a compound having an amino group.

The compounds of (i), (ii) and (iii) above include compounds represented by formulae (4) to (10) and specific examples described in Paragraph Nos. [0142] to [0167] of JP-A-2007-17948. The compound of (iv) above include compounds represented by formula (A'), formulae (a) to (e), formulae (11) to (22) and specific compounds described in Paragraph Nos. [0180] to [0225] of JP-A-2007-17948. The compound of (v) above include compounds represented by formulae (31) and (32) and specific compounds described in Paragraph Nos. [0227] to [0230] of JP-A-2007-17948. In addition to the polyurethane resin described above, a polyurethane resin obtained by introducing a crosslinkable group into polyurethane having a carboxyl group by a polymer reaction as described in JP-A-2003-270775 may also be exemplified.

The binder polymer for use in the invention preferably has an appropriate molecular weight in order to maintain the development property of the image-recording layer of lithographic printing plate precursor. The weight average molecular weight (Mw) thereof in terms of polystyrene measured by GPC method is preferably from 5,000 to 300,000, and more preferably from 20,000 to 150,000.

The binder polymer can be incorporated into the image-recording layer in an arbitrary amount, and the content of the binder polymer in the image-recording layer is preferably from 10 to 90% by weight, more preferably from 30 to 80% by weight, based on the total solid content constituting the image-recording layer.

(D2) Binder polymer for on-press development

In the present invention, it is preferable that an unexposed area of the image-recording layer is capable of being removed with at least one of dampening water and printing ink, and in such case, it is preferable that the image-recording layer contains a binder polymer for on-press development.

As the binder polymer for on-press development, a binder polymer having an alkylene oxide group is preferred.

The binder polymer having an alkylene oxide group for use in the image-recording layer of the lithographic printing plate precursor according to the invention may have a poly(alkylene oxide) moiety in the main chain thereof or in the side chain thereof, or may be a graft polymer having a poly(alkylene oxide) in its side chain or a block copolymer composed of a block constituted by a repeating unit containing a poly(alkylene oxide) and a block constituted by a repeating unit not containing an (alkylene oxide).

In the case where the alkylene oxide group is present in the main chain, a polyurethane resin is preferred. In the case where the alkylene oxide group is present in the side chain, a polymer constituting its main chain includes an acrylic resin, a polyvinyl acetal resin, a polyurethane resin, a polyurea resin, a polyimide resin, a polyamide resin, an epoxy resin, a methacrylic resin, a polystyrene resin, a novolac type phenolic resin, a polyester resin, a synthesis rubber and a natural rubber. In particular, an acrylic resin is preferred.

The alkylene oxide is preferably an alkylene oxide having from 2 to 6 carbon atoms, and particularly preferably an ethylene oxide or a propylene oxide.

A repeating number of alkylene oxide in the poly(alkylene oxide) moiety is from 2 to 120, preferably in a range from 2 to 70, and more preferably in a range from 2 to 50.

It is preferred that the repeating number of alkylene oxide is 120 or less because both the printing durability as to abrasion and the printing durability as to ink receptivity are not decreased.

The poly(alkylene oxide) moiety is preferably introduced into an side chain of the binder as a structure represented by formula (a) shown below. More preferably, it is introduced into a side chain of an acrylic resin as a structure represented by formula (a) shown below.

Formula (a)

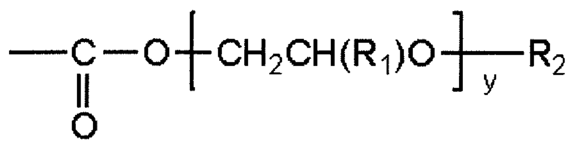

In formula (a), y represents a number from 2 to 120, preferably in a range from 2 to 70, and more preferably in a range from 2 to 50. $R_1$ represents a hydrogen atom or an alkyl group. $R_2$ represents a hydrogen atom or an organic group. The organic group is preferably an alkyl group having from 1 to 6 carbon atoms and includes a methyl group, an ethyl group, an n-propyl group, an isopropyl group, an n-butyl group, a sec-butyl group, an isobutyl group, a tert-butyl group, an n-pentyl group, an isopentyl group, a neopentyl group, an n-hexyl group, an isohexyl group, a 1,1-dimethylbutyl group, a 2,2-dimethylbutyl group, a cyclopentyl group and a cyclohexyl group.

In formula (a), $R_1$ is preferably a hydrogen atom or a methyl group and most preferably a hydrogen atom. $R_2$ is most preferably a hydrogen atom or a methyl group.

The binder polymer may have a crosslinking property in order to improve the film strength of the image area. In order to impart the crosslinking property to the binder polymer, a crosslinkable functional group, for example, an ethylenically unsaturated bond is introduced into a main chain or side chain of the polymer. The crosslinkable functional group may be introduced by copolymerization.

Examples of the polymer having an ethylenically unsaturated bond in the main chain thereof include poly-1,4-butadiene and poly-1,4-isoprene.

Examples of the polymer having an ethylenically unsaturated bond in the side chain thereof include a polymer of an ester or amide of acrylic acid or methacrylic acid, which is a polymer wherein the ester or amido residue (R in -COOR or -CONHR) has an ethylenically unsaturated bond.

Examples of the residue (R described above) having an ethylenically unsaturated bond include $-(CH_2)_nCR^1=CR^2R^3$, $-(CH_2O)_nCH_2CR=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$ and $-(CH_2CH_2O)_2-X$ (wherein $R^1$ to $R^3$ each independently represents a hydrogen atom, a halogen atom or an alkyl group having from 1 to 20 carbon atoms, an aryl group, an alkoxy group or an aryloxy group, or $R^1$ and $R^2$ or $R^1$ and $R^3$ may be combined with each other to form a ring. n represents an integer from 1 to 10. X represents a dicyclopentadienyl residue).

Specific examples of the ester residue include $-CH_2CH=CH_2$ (described in JP-B-7-21633), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$ and $-CH_2CH_2O-X$ (wherein X represents a dicyclopentadienyl residue).

Specific examples of the amido residue include $-CH_2CH=CH_2$, $-CH_2CH_2-Y$ (wherein Y represents a cyclohexene residue) and $-CH_2CH_2-OCO-CH=CH_2$.

The binder polymer having a crosslinking property is cured, for example, by addition of a free radical (a polymerization initiating radical or a growing radical of a polymerizable compound in the process of polymerization) to the crosslinkable functional group of the polymer and undergoing addition polymerization between the polymers directly or through a polymerization chain of the polymerizable compound to form crosslinkage between the polymer molecules. Alternately, it is cured by generation of a polymer radical upon extraction of an atom (for example, a hydrogen atom on a carbon atom adjacent to the functional crosslinkable group) in the polymer by a free radial and connecting the polymer radicals with each other to form cross-linkage between the polymer molecules.

The content of the crosslinkable group (content of the radical polymerizable unsaturated double bond determined by iodine titration) in the binder polymer is preferably from 0.1 to 10.0 mmol, more preferably from 1.0 to 7.0 mmol, most preferably from 2.0 to 5.5 mmol, based on 1 g of the polymer compound. In the range described above, good sensitivity and good preservation stability are obtained.

Specific examples (1) to (13) of the binder polymer for used in the invention are set forth below, but the invention should not be construed as being limited thereto.

In the exemplified compounds described below, a numerical value appended to each repeating unit (numerical value appended to a repeating unit of a main chain) indicates a mole percent of the repeating unit. A numerical value appended to a repeating unit of a side chain indicates a repeating number of the repeating unit.

(1) 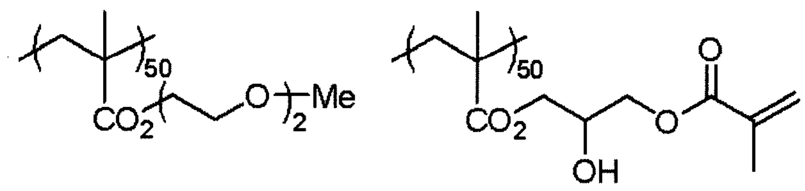

(2) 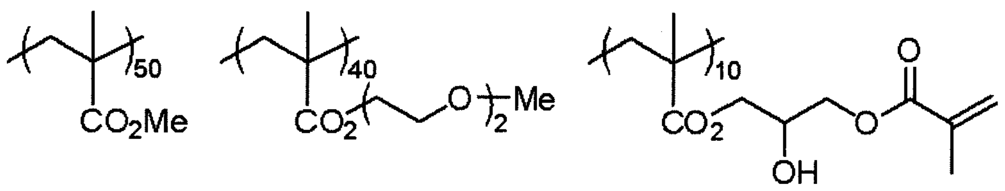

(3) 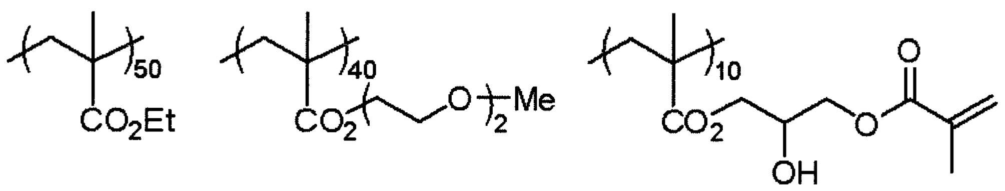

(4) 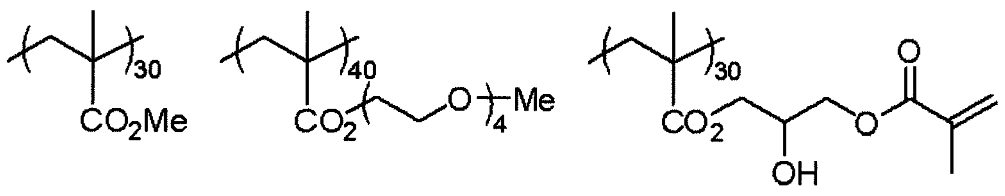

(5) 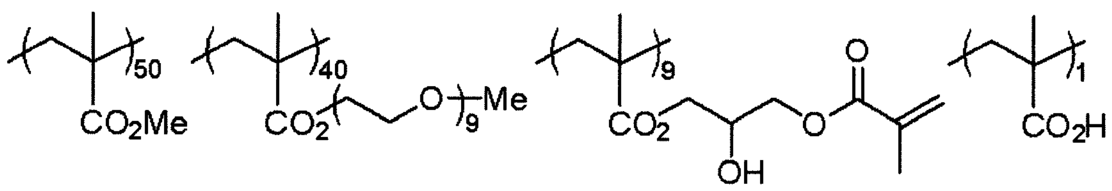

(6) 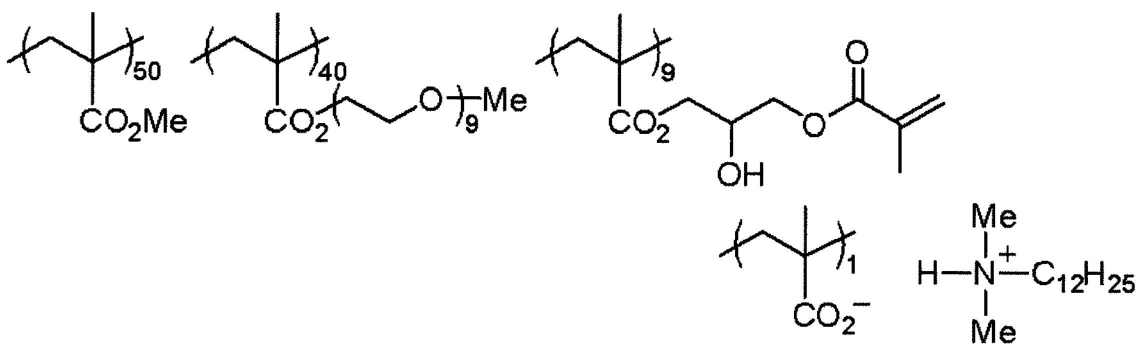

(7) 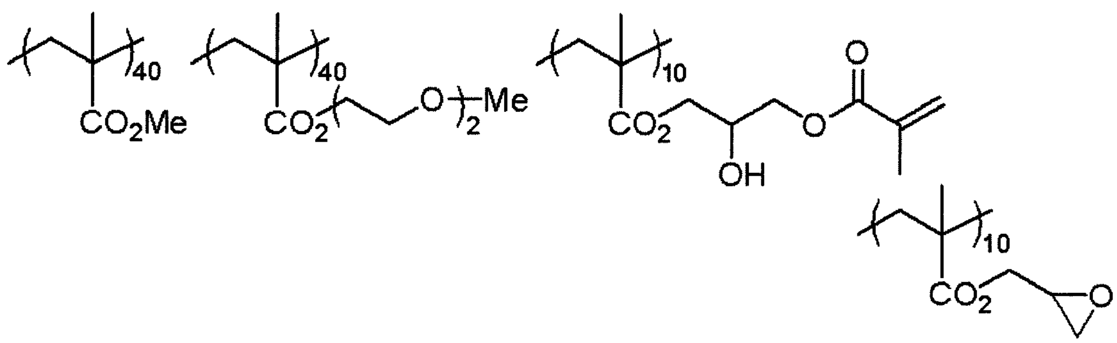

(8) 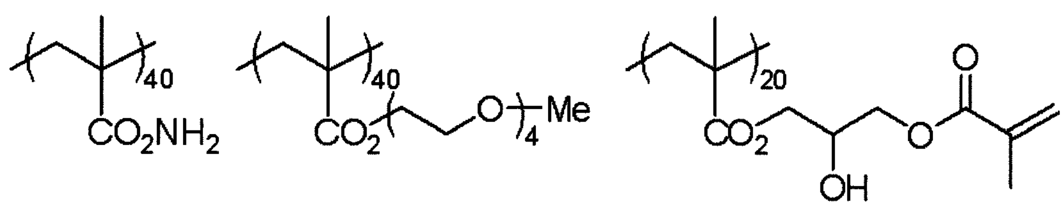

(9) 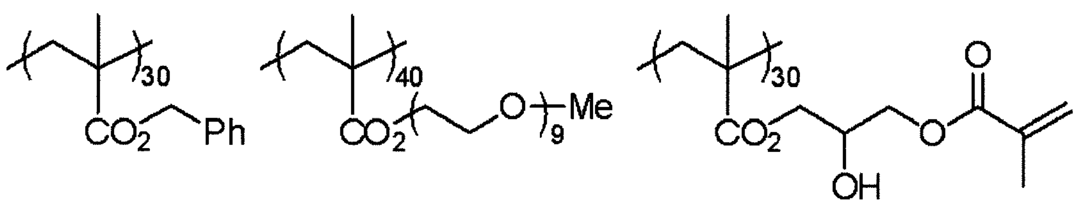

(10)

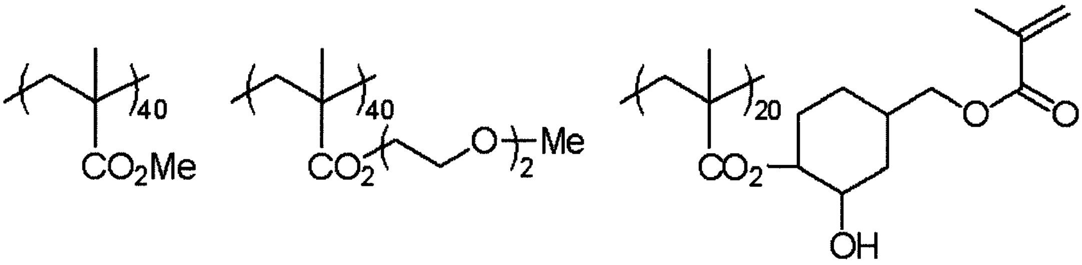

(11)

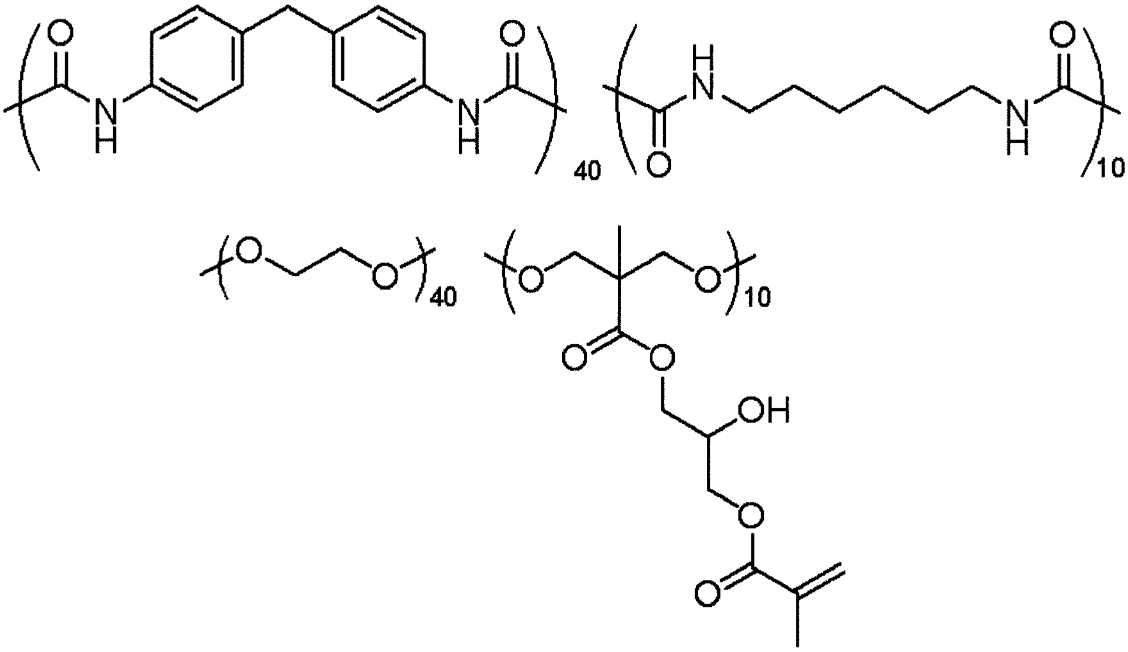

(12)

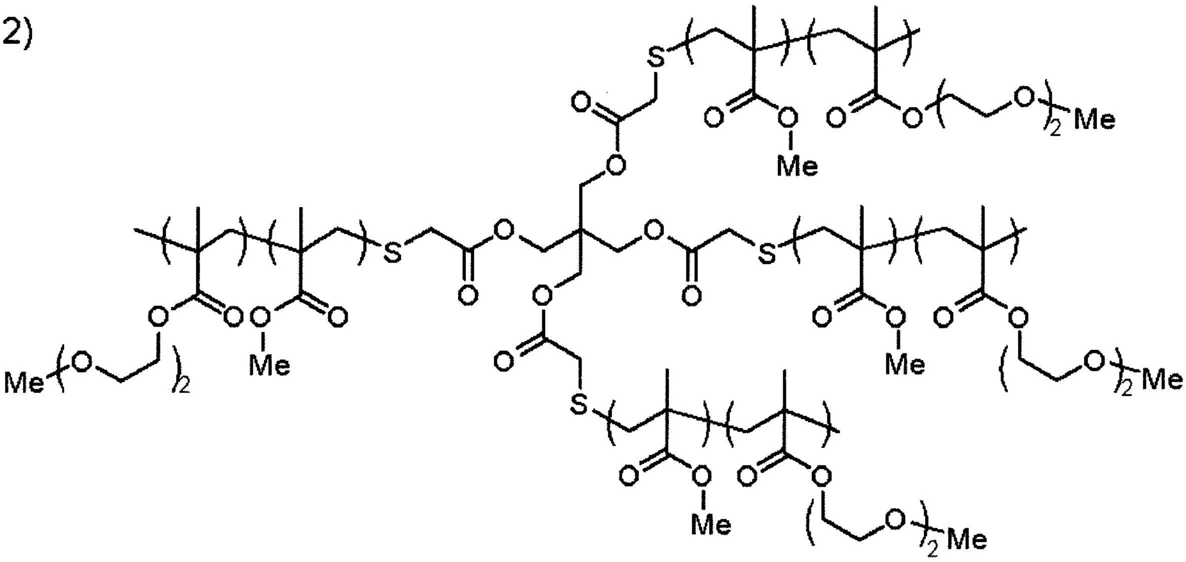

(13)

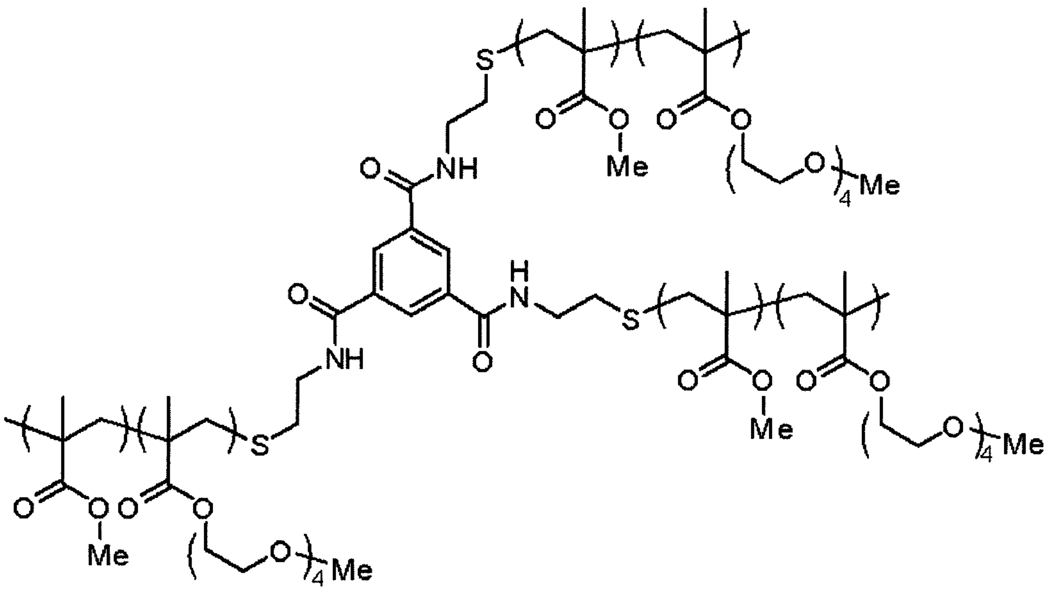

The weight average molecular weight (Mw) of the binder polymer according to the invention is, in terms of polystyrene measured by GPC method, preferably 2,000 or more, more preferably 5,000 or more, and still more preferably from 10,000 to 300,000.

According to the invention, a hydrophilic polymer compound, for example, polyacrylic acid or polyvinyl alcohol described in JP-A-2008-195018 may be used together, if desired. Further, an oleophilic polymer compound may be used in combination with a hydrophilic polymer compound.

In the case of applying to the image-recording layer, as to the configuration of the binder polymer, it may be present as a binder acting as a bond of each ingredient or in the form of fine particle in the image-recording. In the case of existing in the form of fine particle, the average particle size thereof is in a range from 10 to 1,000 nm, preferably in a range from 20 to 300 nm, and particularly preferably in a range from 30 to 120 nm.

The content of the binder polymer according to the invention is preferably from 5 to 90% by weight, more preferably from 5 to 80% by weight, still more preferably from 10 to 70% by weight, based on the total solid content of the image-recording layer.

As a preferred combination of the polymerization initiator, the sensitizing dye, the polymerizable compound and the binder polymer, a combination of the respective preferred embodiments thereof is most preferred.

[Components other than (A) infrared absorbing agent, (B) polymerization initiator, (C) polymerizable compound and (D) binder polymer]

[(E) Polymer fine particle]

The image-recording layer according to the invention may contain a polymer fine particle in order to improve the development property. In particular, a polymer fine particle having a polyalkylene oxide structure is preferred. Among them, a polymer fine particle having a polyalkylene oxide group in its side chain is preferred.

This increases permeability of dampening water to improve the development property. As the polyalkylene oxide structure, an alkylene oxide structure containing from 2 to 120 alkylene oxide units having from 2 to 3 carbon atoms is preferred, and a polyethylene oxide structure containing from 2 to 120 ethylene oxide units is more preferred. Particularly, a polyethylene oxide structure containing from 20 to 100 ethylene oxide units is preferred. By means of such a polymer fine particle containing a polyalkylene oxide structure, compatibility between the printing durability and the development property can be achieved. Also, the ink receptivity can be improved.

The polymer fine particle according to the invention is preferably a hydrophobizing precursor capable of converting the image-recording layer to be hydrophobic when heat is applied. The hydrophobizing precursor polymer fine particle is preferably at least one fine particle selected from a hydrophobic thermoplastic polymer fine particle, a thermoreactive polymer fine particle, a microcapsule having a hydrophobic compound encapsulated and a microgel (crosslinked polymer fine particle). Among them, a polymer fine particle having a polymerizable group and a microgel are preferred. In order to improve the development property, the polymer fine particle may contain a polyalkylene oxide structure as described above.

As the hydrophobic thermoplastic polymer fine particle, hydrophobic thermoplastic polymer fine particles described, for example, in Research Disclosure, No. 33303, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile or polymethyl methacrylate is more preferred.

The average particle size of the hydrophobic thermoplastic polymer fine particle for use in the invention is preferably from 0.01 to 2.0 μm.

The thermo-reactive polymer fine particle for use in the invention includes a polymer fine particle having a thermo-reactive group and forms a hydrophobized region by crosslinkage due to thermal reaction and change in the functional group involved therein.

As the thermo-reactive group of the polymer fine particle having a thermo-reactive group for use in the invention, a functional group performing any reaction can be used as long as a chemical bond is formed. For instance, an ethylenically unsaturated group (for example, an acryloyl group, a methacryloyl group, a vinyl group or an allyl group) performing a radical polymerization reaction, a cationic polymerizable group (for example, a vinyl group or a vinyloxy group), an isocyanate group or a blocked form thereof, an epoxy group or a vinyloxy group performing an addition reaction and a functional group having an active hydrogen atom (for example, an amino group, a hydroxy group or a carboxyl group) as the reaction partner thereof, a carboxyl group performing a condensation reaction and a hydroxy group or an amino group as the reaction partner thereof, and an acid anhydride performing a ring opening addition reaction and an amino group or a hydroxy group as the reaction partner thereof are preferably exemplified.

As the microcapsule for use in the invention, microcapsule having all or part of the constituting components of the image-recording layer encapsulated as described, for example, in JP-A-2001-277740, JP-A-2001-277742 and EP 2383118 is exemplified. The constituting components of the image-recording layer may be present outside the microcapsule. It is a preferred embodiment of the image-recording layer containing microcapsule that hydrophobic constituting components are encapsulated in the microcapsule and hydrophilic constituting components are present outside the microcapsule.

The image-recording layer according to the invention may be an embodiment containing a crosslinked resin particle, that is, a microgel. The microgel can contain a part of the constituting components of the image-recording layer inside and/or on the surface thereof. Particularly, an embodiment of a reactive microgel containing the polymerizable compound (B) on the surface thereof is preferred in view of the image-forming sensitivity and printing durability.

As a method of microencapsulation or microgelation of the constituting components of the image-recording layer, known methods can be used.

The average particle size of the microcapsule or microgel is preferably from 0.01 to 3.0 μm, more preferably from 0.05 to 2.0 μm, particularly preferably from 0.10 to 1.0 μm. In the range described above, good resolution and good time-lapse stability can be achieved.

The content of the polymer fine particle is preferably in a range from 5 to 90% by weight based on the total solid content of the image-recording layer.

[(F) Other components]

The image-recording layer according to the invention may further contain other components described below, if desired.

(F-1) Hydrophilic low molecular weight compound

The image-recording layer according to the invention may contain a hydrophilic low molecular weight compound in order to improve the on-press development property without accompanying the decrease in the printing durability.

The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyol, e.g., glycerol, pentaerythritol or tris(2-hydroxyethyl) isocyanurate, an organic amine, e.g., triethanol amine, diethanol amine or monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.

According to the invention, it is preferred that at least one compound selected from a polyol, an organic sulfate,

an organic sulfonate and a betaine is incorporated.

Specific examples of the organic sulfonate include an alkylsulfonate, for example, sodium n-butylsulfonate, sodium n-hexylsulfonate, sodium 2-ethylhexylsulfonate, sodium cyclohexylsulfonate or sodium n-octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-tetraoxatetracosane-1-sulfonate; an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphtyldisulfonate or trisodium 1,3,6-naphtyltrisulfonate; and compounds described in Paragraph Nos. [0026] to [0031] of JP-A-2007-276454 and Paragraph Nos. [0020] to [0047] of JP-A-2009-154525. The salt may also be a potassium salt or a lithium salt.

The organic sulfate includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt. Specific examples thereof include compounds described in Paragraph Nos. [0034] to [0038] of JP-A-2007-276454.

As the betaine, a compound wherein a number of carbon atoms included in a hydrocarbon substituent on the nitrogen atom is from 1 to 5 is preferred. Specific examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The addition amount of the hydrophilic low molecular weight compound in the image-recording layer is preferably from 0.5 to 20% by weight, more preferably from 1 to 15% by weight, still more preferably from 2 to 10% by weight, based on the total solid content of the image-recording layer. In the range described above, good on-press development property and good printing durability are achieved.

The hydrophilic low molecular weight compounds may be used individually or as a mixture of two or more thereof.

(F-2) Oil-sensitizing agent

In order to improve the ink receptivity, an oil-sensitizing agent, for example, a phosphonium compound, a nitrogen-containing low molecular weight compound or an ammonium group-containing polymer can be used in the image-recording layer according to the invention. In particular, in the case where an inorganic stratiform compound is incorporated into a protective layer, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples thereof include compounds described in Paragraph Nos. [0089] to [0105] of JP-A-2009-208458.

As to the ammonium group-containing polymer, its reduced specific viscosity value (unit: ml/g) determined according to the measuring method described below is preferably in a range from 5 to 120, more preferably in a range from 10 to 110, and particularly preferably in a range from 15 to 100. When the reduced specific viscosity value described above is calculated as weight average molecular weight (Mw) in terms of polystyrene measured by GPC method, from

10,000 to 150,000 is preferred, from 17,000 to 140,000 is more preferred, and 20,000 to 130,000 is particularly preferred.

<Measuring method of reduced specific viscosity>

In a 20 ml measuring flask was weighed 1 g of polymer solid content and the measuring flask is filled up to the gauge line with N-methyl pyrrolidone. The resulting solution was allowed to stand in a thermostatic bath of 30°C for 30 minutes and put into an Ubbelohde viscometer (viscometer constant: 0.010 cSt/s) and a period for running down of the solution at 30°C was measured. The measurement was conducted twice for the same sample and an average value of the measurement was determined. The measurement was also conducted for a blank (only N-methyl pyrrolidone) in the same manner. The reduced specific viscosity (ml/g) was calculated according to the formula shown below.

$$\text{Reduced specific viscosity (ml/g)} = \frac{\dfrac{\text{Period for running down of sample solution (sec)} - \text{Period for running down of blank (sec)}}{\text{Period for running down of blank (sec)}}}{\dfrac{3.33\,(\text{g}) \times \frac{30}{100}}{20\,(\text{ml})}}$$

Specific examples of the ammonium group-containing polymer are set forth below. (1) 2-(Trimethylammonio)ethyl methacrylate p-toluenesulfonate/3,6-dioxaheptyl methacrylate copolymer (molar ratio: 10/90, Mw: 45,000) (2) 2-(Trimethylammonio)ethyl methacrylate hexafluorophosphate/3,6-dioxaheptyl methacrylate copolymer (molar ratio: 20/80, Mw: 60,000) (3) 2-(Ethyldimethylammonio)ethyl methacrylate p-toluenesulfonate/hexyl methacrylate copolymer (molar ratio: 30/70, Mw: 45,000) (4) 2-(Trimethylammonio)ethyl methacrylate hexafluorophosphate /2-ethylhexyl methacrylate copolymer (molar ratio: 20/80, Mw: 60,000) (5) 2-(Trimethylammonio)ethyl methacrylate methylsulfate/hexyl methacrylate copolymer (molar ratio: 40/60, Mw: 70,000) (6) 2-(Butyldimethylammonio)ethyl methacrylate hexafluorophosphate/3,6-dioxaheptyl methacrylate copolymer (molar ratio: 25/75, Mw: 65,000) (7) 2-(Butyldimethylammonio)ethyl acrylate hexafluorophosphate/3,6-dioxaheptyl methacrylate copolymer (molar ratio: 20/80, Mw: 65,000) (8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80, Mw: 75,000) (9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5, Mw: 65,000)

The content of the oil-sensitizing agent is preferably from 0.01 to 30.0% by weight, more preferably from 0.1 to 15.0% by weight, still more preferably from 1 to 10% by weight, based on the total solid content of the image-recording layer.

(F-3) Other components

Other components, for example, a surfactant, a coloring agent, a print-out agent, a polymerization inhibitor, a higher fatty acid derivative, a plasticizer, an inorganic fine particle, an inorganic stratiform compound, a sensitizing aid or a chain transfer agent may further be added to the image-recording layer. Specifically, compounds and addition amounts thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

[Formation of image-recording layer]

The image-recording layer according to the invention is formed by dispersing or dissolving each of the necessary components described above in a known solvent to prepare a coating solution and coating the solution on a support by a known method, for example, bar coater coating and drying as described, for example, in Paragraph Nos. [0142] to [0143] of JP-A-2008-195018. The coating amount (solid content) of the image-recording layer formed on the support after coating and drying may be varied according to the intended purpose but is in general preferably from 0.3 to 3.0 $g/m^2$. In the range described above, good sensitivity and good film property of the image-recording layer can be achieved.

[Undercoat layer]

In the lithographic printing plate precursor according to the invention, it is preferred to provide an undercoat layer (also referred to as an intermediate layer) between the image-recording layer and the support. The undercoat layer strengthens adhesion between the support and the image-recording layer in the exposed area and makes removal of the image-recording layer from the support easy in the unexposed area, thereby contributing improvement in the development property without accompanying degradation of the printing durability. Further, in the case of infrared laser exposure, since the undercoat layer acts as a heat insulating layer, decrease in sensitivity due to diffusion of heat generated upon the exposure into the support is prevented.

As to a compound for use in the undercoat layer, an undercoat layer containing an acid group, for example, phosphonic acid, phosphoric acid or sulfonic acid is preferably used. Further, a compound having an adsorbing group capable of adsorbing to a surface of support and a crosslinkable group in order to improve an adhesion property to the image-recording layer is preferred. The compound may be a low molecular weight compound or a polymer compound. The compounds may be used in mixture of two or more thereof, if desired.

As the polymer compound, a copolymer of a monomer having an adsorbing group, a monomer having a hydrophilic group and a monomer having a crosslinkable group is preferred. As the adsorbing group capable of adsorbing to a surface of support, a phenolic hydroxy group, a carboxyl group, $-PO_3H_2$, $-OPO_3H_2$, $-CONHSO_2-$, $-SO_2NHSO_2-$ or $-COCH_2COCH_3$ is preferred. As the hydrophilic group, a sulfo group is preferred. As the crosslinkable group, for example, a methacryl group or an allyl group is preferred. The polymer compound may contain a crosslinkable group introduced by a salt formation between a polar substituent of the polymer compound and a compound containing a substituent having a counter charge to the polar substituent of the polymer compound and an ethylenically unsaturated bond and may also be further copolymerized with a monomer other than those described above, preferably a hydrophilic monomer.

Specifically, a silane coupling agent having an addition-polymerizable ethylenic double bond reactive group described in JP-A-10-282679 and a phosphorus compound having an ethylenic double bond reactive group described in JP-A-2-304441 are preferably exemplified. Low molecular weight compounds or polymer compounds having a crosslinkable group (preferably an ethylenically unsaturated bond group), a functional group capable of interacting with a surface of support and a hydrophilic group described in JP-A-2005-238816, JP-A-2005-125749, JP-A-2006-239867, JP-A-2006-215263 and JP-A-2011-245846 are also preferably used. Polymer compounds having an adsorbing group capable of adsorbing to a surface of support, a hydrophilic group and a crosslinkable group described in JP-A-2005-125749, JP-A-2006-188038 and JP-A-2011-245846 are more preferred.

The content of the unsaturated double bond in the polymer compound for undercoat layer is preferably from 0.1 to 10.0 mmol, most preferably from 0.2 to 5.5 mmol, based on 1 g of the polymer compound.

The weight average molecular weight of the polymer compound for undercoat layer is preferably 5,000 or more, and more preferably from 10,000 to 300,000.

The undercoat layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazabicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compound for the undercoat layer described above in order to prevent the occurrence of stain due to the lapse of time.

The undercoat layer is coated according to a known method. The coating amount (solid content) of the undercoat layer is preferably from 0.1 to 100 $mg/m^2$, and more preferably from 1 to 30 $mg/m^2$.

[Support]

As the support for use in the light-sensitive lithographic printing plate precursor according to the invention, a known support is employed. Particularly, an aluminum plate subjected to roughening treatment and anodizing treatment according to a known method is preferred.

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 $\mu m$.

The support for use in the lithographic printing plate precursor according to the invention may have a backcoat layer containing an organic polymer compound described in JP-A-5-45885 or an alkoxy compound of silicon described in JP-A-6-35174, provided on the back surface thereof, if desired.

[Protective layer]

In the lithographic printing plate precursor for use in the method according to the invention, it is preferred to provide a protective layer (an overcoat layer) on the image-recording layer. The protective layer has a function for preventing, for example, occurrence of scratch in the image-recording layer or ablation caused by exposure with high illuminance laser, in addition to the function for restraining an inhibition reaction against the image formation by means of oxygen blocking.

The protective layer in the lithographic printing plate precursor according to the invention may be formed from two or more layers. For example, the protective layer may be constituted from two layer constitution of an upper protective layer and a lower protective layer.

With respect to the protective layer having such properties, there are described, for example, in U.S. Patent 3,458,311 and JP-B-55-49729. As a polymer having low oxygen permeability for use in the protective layer, any water-soluble polymer and water-insoluble polymer can be appropriately selected to use. The polymers may be used in mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified.

As the modified polyvinyl alcohol, an acid-modified polyvinyl alcohol having a carboxyl group or a sulfo group is preferably used. Specifically, modified polyvinyl alcohols described in JP-A-2005-250216 and JP-A-2006-259137 are preferably exemplified.

In the protective layer, a hydrophilic polymer containing at least a repeating unit represented by formula (1) shown below and a repeating unit represented by formula (2) shown below as described in JP-A-2012-73597 can be used.

In particular, the protective layer preferably contains a hydrophilic polymer containing repeating units represented by formulae (1) and (2) shown below (hereinafter, also referred to as a specific hydrophilic polymer (e)).

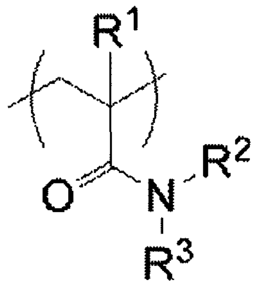

Formula (1)

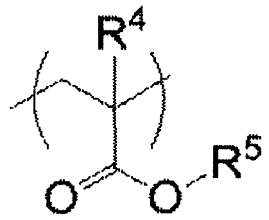

Formula (2)

In formulae (1) and (2), $R^1$ and $R^4$ each independently represents a hydrogen atom or a methyl group. $R^2$ and $R^3$ each independently represents a hydrogen atom, a methyl group or an ethyl group. $R^5$ represents an unsubstituted straight-chain, branched or cyclic alkyl group having from 2 to 8 carbon atoms, a substituted alkyl group which may have an aromatic ring or a heterocyclic ring as a substituent or a substituent represented by formula (3) shown below.

As the substituent which can be introduced into the substituted alkyl group, an aromatic ring group, a heterocyclic group and a polyether group are exemplified.

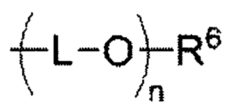

Formula (3)

In formula (3), L represents an alkylene group having from 2 to 6 carbon atoms, $R^6$ represents a straight-chain, branched or cyclic alkyl group having from 4 to 8 carbon atoms or an aromatic group-substituted alkyl group, and n means an average addition molar number of polyether and represents a number from 2 to 4.

In the repeating unit represented by formula (1), $R^2$ and $R^3$ each preferably represents a hydrogen atom. In the repeating unit represented by formula (2), $R^5$ preferably represents an unsubstituted straight-chain, branched or cyclic alkyl group having from 2 to 8 carbon atoms.

Of the combinations of the repeating units represented by formulae (1) and (2) respectively, a combination where $R^1$ and $R^4$ in formulae (1) and (2) are both hydrogen atoms, $R^2$ and $R^3$ in formula (1) are both hydrogen atoms,

and $R^5$ in formula (2) is an unsubstituted branched alkyl group having 4 carbon atoms is most preferred.

The specific hydrophilic polymer (e) is preferably a hydrophilic polymer containing a repeating unit represented by formula (4) shown below.

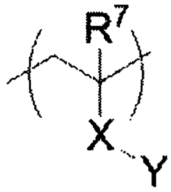

Formula (4)

In formula (4), $R^7$ represents a hydrogen atom or a methyl group. X represents a single bond, a divalent connecting group selected from structures described in structure group (5) shown below or a divalent connecting group formed by combination of plural structures selected from structures described in structure group (5) shown below. Y represents a carboxylic acid group, a carboxylic acid salt group, a sulfonic acid group, a sulfonic acid salt group, a phosphoric acid group, a phosphoric acid salt group, a phosphonic acid group, a phosphonic acid salt group, a hydroxy group, a carboxybetaine group, a sulfobetaine group, an ammonium group or a polyether group represented by formula (6) shown below.

In the repeating unit represented by formula (4), from the standpoint of water solubility and on-press development property, Y is preferably a sulfonic acid group, a sulfonic acid salt group, a carboxybetaine group, a sulfobetaine group or an ammonium group, and more preferably a sulfonic acid group, a sulfonic acid salt group or a sulfobetaine group.

Also, X is preferably a divalent connecting group selected from structures described in structure group (5) shown below.

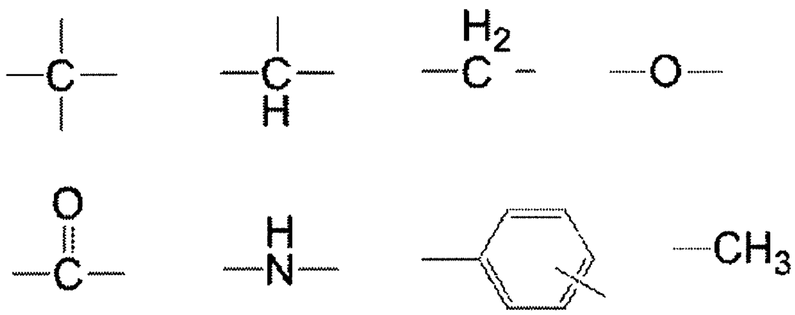

Structure group (5)

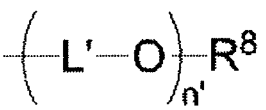

Formula (6)

In formula (6), L' represents an alkylene group having from 2 to 3 carbon atoms. $R^8$ represents a hydrogen atom or a methyl group. n' means an average addition molar number of polyether and represents a number from 2 to 4.

Specific examples of a monomer from which the repeating unit represented by formula (1) is derived include acrylamide, methacrylamide, N-methylacrylamide, N-methylmethacrylamide, N-ethylacrylamide, N-ethylmethacrylamide, N,N-dimethylacrylamide, N,N-dimethylmethacrylamide, N,N-diethylacrylamide, N,N-diethylmethacrylamide, N,N-ethylmethylacrylamide and N,N-ethylmethylmethacrylamide.

Specific examples of a monomer from which the repeating unit represented by formula (2) is derived include methyl acrylate, ethyl acrylate, propyl acrylate, isopropyl acrylate, n-butyl acrylate, isobutyl acrylate, tert-butyl acrylate, pentyl acrylate, hexyl acrylate, cyclohexyl acrylate, heptyl acrylate, octyl acrylate, 2-ethylhexyl acrylate, nonyl acrylate, decyl acrylate, 2-(2-ethylhexyloxyethoxy)ethyl acrylate, methyl methacrylate, ethyl methacrylate, propyl methacrylate,

isopropyl methacrylate, n-butyl methacrylate, isobutyl methacrylate, tert-butyl methacrylate, pentyl methacrylate, hexyl methacrylate, cyclohexyl methacrylate, heptyl methacrylate, octyl methacrylate, 2-ethylhexyl methacrylate, nonyl methacrylate and decyl methacrylate.

The content of the repeating unit represented by formula (1) is preferably from 65 to 96.7% by mole, more preferably from 70 to 80% by mole, particularly preferably from 74 to 80% by mole. The content of the repeating unit represented by formula (2) is preferably from 3 to 30% by mole, more preferably from 20 to 30% by mole, particularly preferably from 20 to 26% by mole.

Specific examples of a monomer from which the repeating unit represented by formula (4) is derived include 2-acryloylamino-2-methylpropanesulfonic acid, sodium 2-acryloylamino-2-methylpropanesulfonate, potassium 2-acryloylamino-2-methylpropanesulfonate, 4-((3-methacrylamidopropyl)dimethylammonio)butane-1-sulfonate, 4-((3-acrylamidopropyl)dimethylammonio)butane-1-sulfonate, vinyl alcohol, acrylic acid, methacrylic acid, sodium styrenesulfonate, diethylene glycol monomethyl ether methacrylate, hydroxyethyl acrylate, hydroxyethyl methacrylate, methacrylcholine chloride, potassium 3-sulfopropylmethacrylate, 2-(methacryloyloxy)ethyl phosphate, dimethyl-N-methacryloyloxyethyl-N-carboxymethyl-ammonium betaine and vinylphosphonic acid.

The specific hydrophilic polymer (e) contains the repeating unit represented by formula (4) preferably in a range from 0.3 to 5% by mole, more preferably from 0.3 to 3% by mole, and still more preferably from 0.3 to 1.5% by mole.

By incorporating the repeating unit represented by formula (4) into the hydrophilic polymer used in the protective layer according to the invention in the preferred range described above, the light-sensitive lithographic printing plate precursor for use in the invention provides good on-press development property, ink receptivity and printing durability.

The weight average molecular weight (Mw) of the hydrophilic polymer according to the invention in terms of polystyrene measured by GPC method is preferably in a range from 10,000 to 200,000, more preferably in a range from 10,000 to 100,000, and most preferably in a range from 10,000 to 30,000.

Specific examples of the hydrophilic polymer according to the invention are set forth below. The ratio of the respective repeating units is recited as mole fraction, and Mw of the hydrophilic polymer is each 20,000.

The content of the specific hydrophilic polymer (e) in the protective layer is preferably 40% by weight or more, more preferably from 60% by weight or more, particularly preferably from 80% by weight or more, based on the solid content of the protective layer. In the range described above, a lithographic printing plate having better ink receptivity and higher printing durability is provided and a lithographic printing plate precursor more excellent in on-press development property is obtained.

1 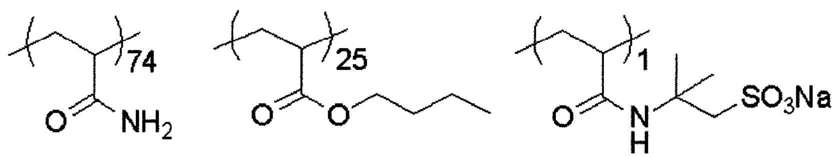

2 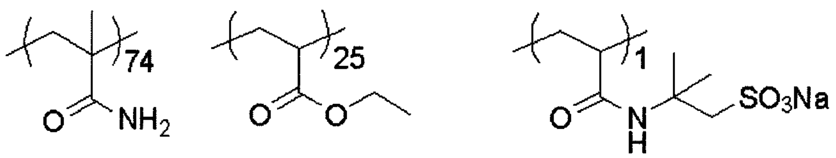

3 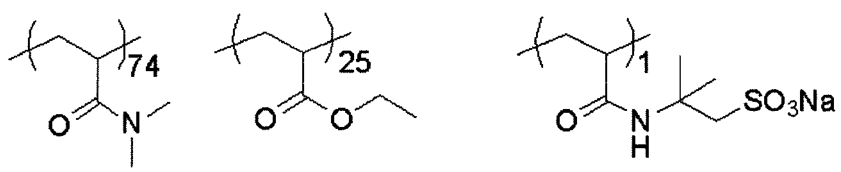

4 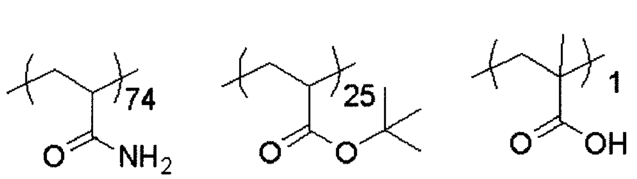

5 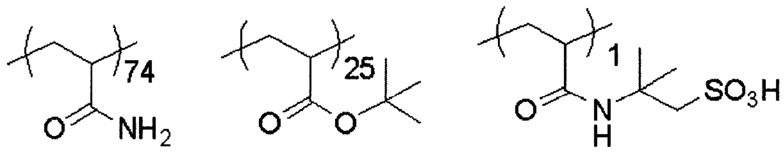

6 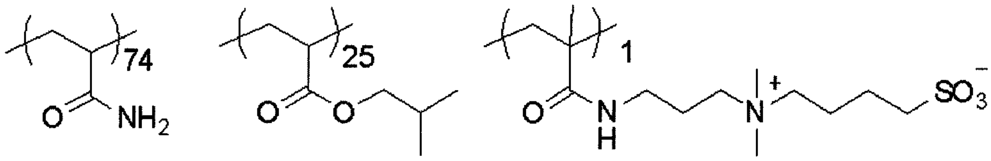

Also, the protective layer preferably contains a stratiform compound which is inorganic (called also as "an inorganic stratiform compound"), for example, natural mica or synthetic mica, as described in JP-A-2005-119273 in order to increase the oxygen blocking property.

Further, the protective layer may contain known additives, for example, a plasticizer for imparting flexibility, a surfactant for improving coating property, an inorganic fine particle for controlling a surface slipping property or an ultraviolet absorbing agent. Moreover, the oil-sensitizing agent described with respect to the image-recording layer may also be incorporated into the protective layer.

The adhesion property to the image-recording layer and scratch resistance are also extremely important in view of handling of the lithographic printing plate precursor. Specifically, when a hydrophilic protective layer containing a water-soluble polymer as the main component is stacked on the oleophilic image-recording layer, layer peeling due to an insufficient adhesion property is liable to occur, and the peeled portion causes such a defect as failure in curing of the image-recording layer due to polymerization inhibition by oxygen. Various proposals have been made for improving the adhesion property between two layers. For example, it is described in JP-B-54-12215 and BP-A-1303578 that a sufficient adhesion property can be obtained by mixing from 20 to 60% by weight of an acryl emulsion or a water-insoluble vinyl pyrrolidone/vinyl acetate copolymer in the protective layer. Any of these known techniques can be applied to the protective layer according to the invention.

As to a coating method of the protective layer, known methods described, for example, in U.S. Patent 3,458,311 and JP-B-55-49729 can be applied. The coating amount of the protective layer is preferably in a range from 0.01 to 10 $g/m^2$, more preferably in a range from 0.02 to 3 $g/m^2$, most preferably in a range from 0.02 to 1 $g/m^2$, in terms of the coating amount after drying.

Thus, a light-sensitive lithographic printing plate precursor applied to the method according to the invention can be obtained.

[Plate making method]

The plate making method of the lithographic printing plate according to the invention includes at least a process of image exposure of the lithographic printing plate precursor (hereinafter, also referred to as an "exposure process") and a process of development processing of the exposed lithographic printing plate precursor with a processing solution (hereinafter, also referred to as a "development process").

<Exposure process>

The lithographic printing plate precursor for use in the invention is preferably exposed using a light source of wavelength from 750 to 1,400 nm. As such a light source, a solid laser or semiconductor laser emitting an infrared ray is preferably used, and in particular, a method of image exposure by conducting scanning exposure with such an infrared laser is preferred. The exposure mechanism may be any of an internal drum system, an external drum system and a flatbed system.

<Development process>

It is preferred that after the image exposure, the lithographic printing plate precursor for use in the invention is developed by removing the unexposed area of the image-recording layer with water or a developer having pH from 2 to 14 (developer processing), or is mounted on a printing machine (more specifically, a cylinder of printing machine) and developed by removing the unexposed area of the image-recording layer with at least one of oily ink and an aqueous component (on-press development).

The developer processing is ordinarily practiced according to the following processes: (1) removing the non-image area with a developer, (2) conducting gumming solution treatment and (3) drying in a drying process. Although the lithographic printing plate precursor for use in the invention can be developed according to the ordinary processes described above (conventional development), it is preferred to conduct processes (1) and (2) simultaneously (simple development). In any of the development methods, a water washing process for removing a protective layer may be provided before process (1). The development of process (1) is conducted according to a conventional manner at temperature approximately from 0 to 60°C, preferably approximately from 15 to 40°C, using, for example, a method wherein the lithographic printing plate precursor subjected to the exposure treatment is immersed in a developer and rubbed with a brush or a method wherein a developer is sprayed to the lithographic printing plate precursor subjected to the exposure treatment by a spray and the lithographic printing plate precursor is rubbed with a brush.

In the case of the conventional development, a water washing process for removing an excess developer may be provided between process (1) and process (2). The developer used in process (1) is preferably a known alkali developer.

In the case of the simple development, it is preferred that after the development and gumming treatment, an excess developer is removed using a squeeze roller and then drying is conducted.

The developer for use in the simple development is an aqueous solution having pH from 2 to 11. An aqueous solution containing water as the main component (containing 60% by weight or more of water) is preferred. In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is preferably from 5 to 10.7, more preferably from 6 to 10.5, and most preferably from 7.5 to 10.3.

Further, in the plate making process of preparing a lithographic printing plate from the lithographic printing plate precursor according to the invention, the lithographic printing plate precursor may be heated its entire surface before or during the exposure or between the exposure and the development, if desired. By the heating, the image-forming reaction in the image-recording layer is accelerated and advantages, for example, improvement in the sensitivity and printing durability and stabilization of the sensitivity are achieved. For the purpose of increasing the image strength and printing durability, it is also effective to perform entire surface after-heating or entire surface exposure of the image after the development. Ordinarily, the heating before the development is preferably performed under a mild condition of 150°C or lower. When the temperature is too high, a problem may arise sometimes in that the unexposed area is also cured. In the heating after the development, very strong conditions are utilized. Ordinarily, the temperature is in a range from 100 to 500°C. When the temperature is too low, a sufficient effect of strengthening the image may not be obtained, whereas when it is excessively high, problems of deterioration of the support and thermal decomposition of the image area may occur sometimes.

The lithographic printing plate precursor according to the invention can also be subjected to plate making by an on-press development method. The on-press development method includes a process in which the lithographic printing plate precursor is imagewise exposed and a printing process in which at least one of oily ink and an aqueous component is supplied to the exposed lithographic printing plate precursor without undergoing any development processing to perform printing, and it is characterized in that the unexposed area of the lithographic printing plate precursor is removed in the course of the printing process. The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing process. Then, the printing operation is initiated using the printing machine with supplying at least one of oily ink and an aqueous component and at an early stage of the printing the on-press development is carried out. Specifically, the image-recording layer in the unexposed area is removed and the hydrophilic surface of support is revealed therewith to form the non-image area. As the oily ink and the aqueous component, printing ink and dampening water for conventional lithographic printing can be employed, respectively.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

EXAMPLES

The invention will be described in more detail with reference to the following examples, but the invention should not be construed as being limited thereto. With respect to the polymer compounds used in the examples, unless otherwise particularly defined, a molecular weight means a weight average molecular weight (Mw) in terms of polystyrene measured by GPC method and a ratio of repeating units is indicated in mole percent.

1. Production of lithographic printing plate precursor of on-press development type (for Examples 1 to 39 and Comparative Examples 1 to 7)

<Production of support>

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/$cm^3$) of pumice having a median size of 25 μm, followed by thorough washing with water. The plate was subjected to etching by immersing in 25% by weight aqueous sodium hydroxide of 45°C for 9 seconds, washed with water, then immersed in a 20% by weight nitric acid solution at 60°C for 20 seconds, and washed with water. The etching amount of the grained surface was about 3 g/$m^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/$dm^2$ in terms of the peak value of the electric current, and 5% of the electric current flowing from the electric source was divided to the auxiliary anode. The quantity of electricity in the nitric acid electrolysis was 175 C/$dm^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/$dm^2$ in terms of the quantity of electricity when the aluminum plate functioned as an anode. The plate was then washed with water by spraying.

The plate was then subjected to an anodizing treatment using as an electrolytic solution, 15% by weight sulfuric acid (containing 0.5% by weight of aluminum ion) at a current density of 15 A/$dm^2$ to form a direct current anodized film of 2.5 g/$m^2$, washed with water and dried to produce Support A.

Thereafter, in order to ensure the hydrophilicity of the non-image area, Support A was subjected to silicate treatment using a 2.5% by weight aqueous sodium silicate No. 3 solution at 60°C for 10 seconds and then was washed with water to obtain Support B. The adhesion amount of Si was 10 mg/$m^2$. The center line average roughness (Ra) of the support was measured using a stylus having a diameter of 2 μm and found to be 0.51 μm.

<Formation of undercoat layer>

Coating solution (A) for undercoat layer shown below was coated on Support B described above so as to have a dry coating amount of 20 mg/$m^2$ to produce a support having an undercoat layer shown below.

<Coating solution (A) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

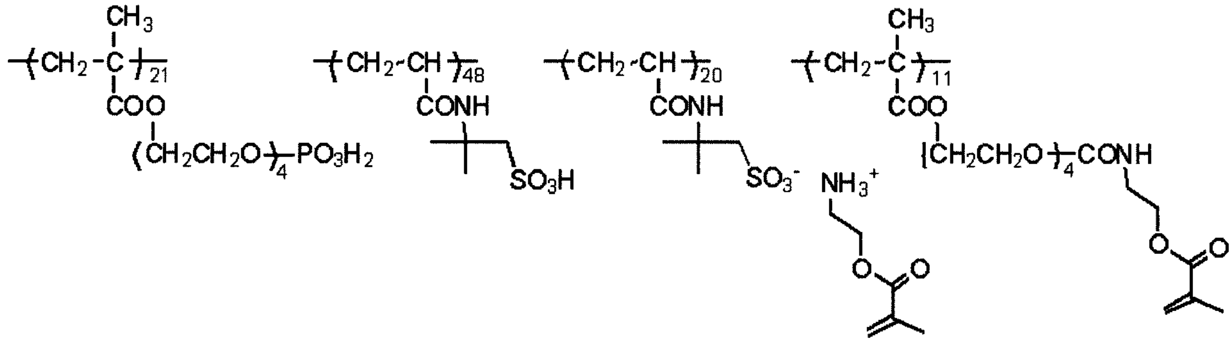

(Mw: 100,000)

Compound (1) for undercoat layer

<Formation of image-recording layer>

Coating solution (1) for image-recording layer having the composition shown below was coated on the undercoat layer formed as described above by a bar and dried in an oven at 100°C for 60 seconds to form an image-recording layer having a dry coating amount of 1.0 g/$m^2$.

Coating solution (1) for image-recording layer was prepared by mixing the photosensitive solution shown below with the microgel solution shown below just before the coating, followed by stirring.

<Photosensitive solution>

| | |
|---|---|
| Binder polymer (2) having structure shown below | 0.240 g |
| Infrared absorbing agent (IR-10) | 0.030 g |
| Sulfonium salt (compound shown in Table 1) | 0.200 g |
| Borate compound (TPB having structure shown below) | 0.015 g (in case of addition) |
| Polymerizable compound | 0.192 g |
| Tris(acryloyloxyethyl) isocyanurate (NK ESTER A-9300, produced by Shin-Nakamura Chemical Co., Ltd.) | |
| Hydrophilic low molecular weight compound | 0.062 g |
| Tris(2-hydroxyethyl) isocyanurate | |
| Hydrophilic low molecular weight compound (1) having structure shown below | 0.050 g |
| Oil-sensitizing agent (Phosphonium compound (1) having structure shown below) | 0.055 g |
| Oil-sensitizing agent | 0.018 g |
| Benzyl dimethyl octyl ammonium $PF_6$ salt | |
| Oil-sensitizing agent (Ammonium group-containing polymer having structure shown below (reduced specific viscosity: 44 ml/g)) | 0.035 g |
| Fluorine-based surfactant (1) having structure shown below | 0.008 g |
| 2-Butanone | 1.091 g |
| 1-Methoxy-2-propanol | 8.609 g |

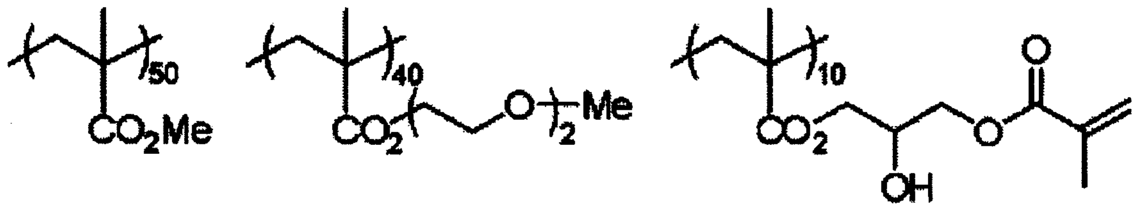

Mw: 70,000

Binder polymer (2)

<Microgel solution>

| | |
|---|---|
| Microgel | 2.640 g |
| Distilled water | 2.425 g |

The structures of Fluorine-based surfactant (1), Hydrophilic low molecular weight compound (1), Phosphonium compound (1), Ammonium group-containing polymer and TPB used in Coating solution (1) for image-recording layer, and the synthesis method of microgel used in Coating solution (1) for image-recording layer are as shown below.

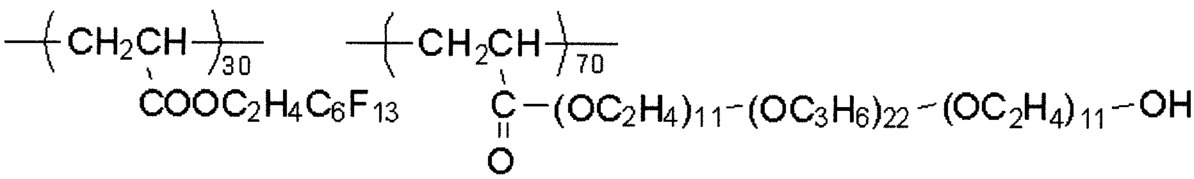

(Mw: 13,000)

Fluorine-based surfactant (1)

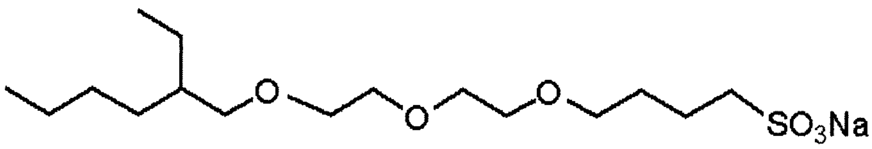

Hydrophilic low molecular weight compound (1)

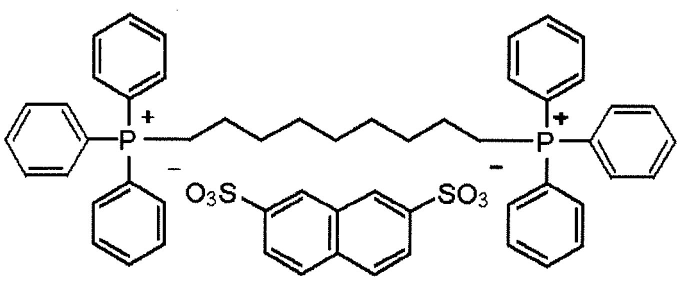

Phosphonium compound (1)

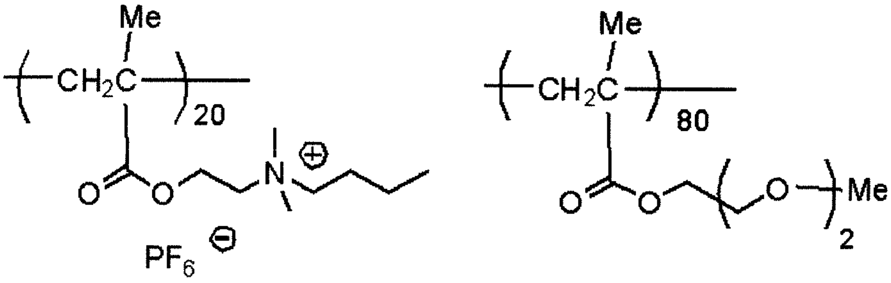

Ammonium group-containing polymer

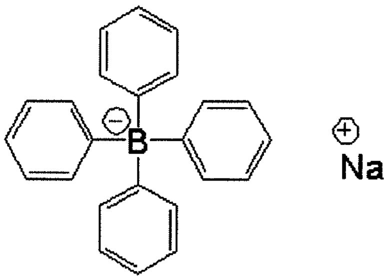

TPB

Also, R-1 to R-7 described in the table are as shown below.

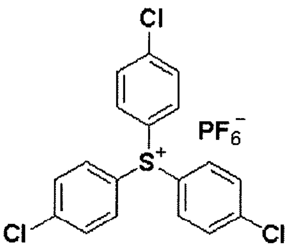

R-1

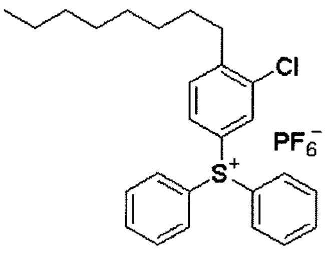

R-2

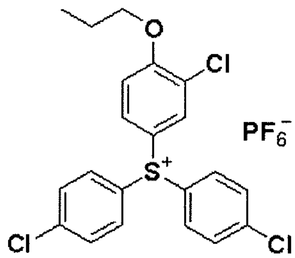

R-3

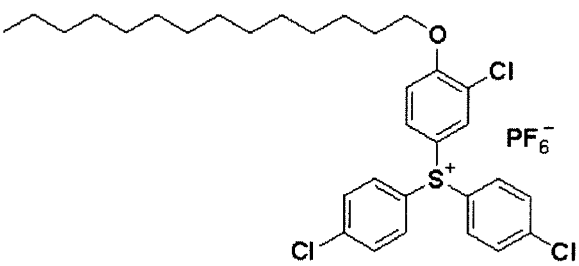

R-4

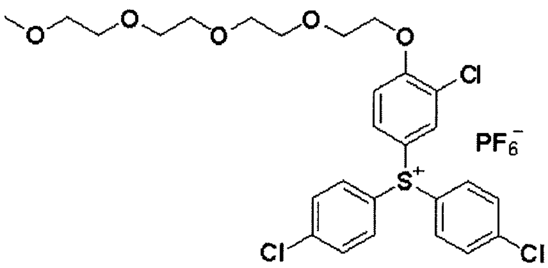

R-5

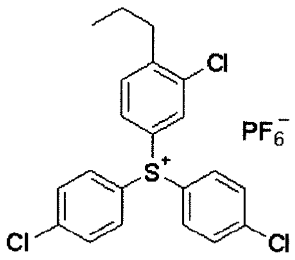

R-6

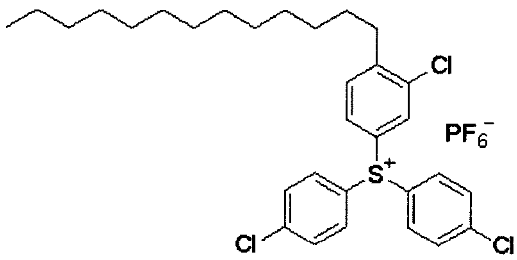

R-7

<Synthesis of microgel>

An oil phase component was prepared by dissolving 10 g of adduct of trimethylolpropane and xylene diisocyanate (TAKENATE D-110N, produced by Mitsui Chemicals Inc.), 3.15 g of pentaerythritol triacrylate (SR444, produced by Nippon Kayaku Co., Ltd.) and 0.1 g of an alkylbenzenesulfonate (PIONIN A-41C, produced by Takemoto Oil & Fat Co., Ltd.) in 17 g of ethyl acetate. As an aqueous phase component, 40 g of an aqueous 4% by weight solution of polyvinyl alcohol (PVA-205, produced by Kuraray Co., Ltd) was prepared. The oil phase component and the aqueous phase component were mixed and the mixture was emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid content concentration of 15% by weight to prepare the microgel. The average particle size of the microgel was measured by a light scattering method and found to be 0.2 $\mu$m.

<Formation of protective layer>

Coating solution for protective layer having the composition shown below was further coated on the image-recording layer described above by a bar and dried in an oven at 120°C for 60 seconds to form a protective layer having a dry coating amount of 0.15 g/m$^2$, thereby producing a lithographic printing plate precursor.

<Coating solution for protective layer>

| | |
|---|---|
| Dispersion of inorganic stratiform compound (1) | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of polyoxyethylene lauryl ether (surfactant, EMALEX 710, produced by Nihon Emulsion Co., Ltd.) | 0.86 g |
| Ion-exchanged water | 6.0 g |

<Preparation of Dispersion of inorganic stratiform compound (1)>

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 $\mu$m. The aspect ratio of the particle thus-dispersed was 100 or more.

<Evaluation of lithographic printing plate precursor>

(i) On-press development property

The lithographic printing plate precursor obtained was exposed by LUXEL PLATESETTER T-6000III equipped with an infrared semiconductor laser (produced by Fujifilm Corp.) under the conditions of a rotational number of an

external drum of 1,000 rpm, laser output of 70% and resolution of 2,400 dpi. The exposed image contained a solid image and a 50% halftone dot chart of a 20 μm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by Fujifilm Corp.)/tap water = 2/98 (by volume ratio)) and SPACE COLOR FUSION-G (N) Black Ink (produced by DIC Graphics Corp.), the dampening water and ink were supplied according to the standard automatic printing start method of LITHRONE 26 to conduct printing on 100 sheets of TOKUBISHI art paper (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property.

The results are shown in Table 1.

(ii) Printing durability

After performing the evaluation for the on-press development property just after the production described above, the printing was continued. As the increase in a number of printing papers, the image-recording layer was gradually abraded to cause decrease in the ink density on a printed material. A number of printed materials wherein a value obtained by measuring a halftone dot area ratio of the 50% halftone dot of FM screen on the printed material using a Gretag densitometer decreased by 5% from the value measured on the 100th paper of the printing was regarded as a number of printed materials at the completion of printing to evaluate the printing durability. The results are shown in Table 1.

(iii) Tone reproducibility

The lithographic printing plate precursor obtained was exposed under the conditions shown below in the same manner as in the evaluation for the on-press development property described above, conducted the on-press development in the same manner as described above, and a halftone dot area ratio of the exposed area and the unexposed area on the 100th printed material was measured by a halftone dot percent measuring device iCPlate II to evaluate. As the evaluation result is closer to 50, it is meant that the tone reproducibility is more excellent. The results are shown in Table 1. As to the exposure conditions, the exposure was conducted by LUXEL PLATESETTER T-6000III (produced by Fujifilm Corp.) under the conditions of a rotational number of an external drum of 400 rpm, laser output of 85% and resolution of 2,400 dpi. The exposed image contained a 50% halftone dot chart of AM 200 lines.

TABLE 1

| | Sulfonium Salt | Aid | On-press Development Property (sheets) | Printing Durability (10,000 sheets) | Tone Reproducibility (%) |
|---|---|---|---|---|---|
| Example 1 | S-1 | -- | 30 | 7 | 51 |
| Example 2 | S-2 | -- | 30 | 7 | 51 |
| Example 3 | S-3 | -- | 30 | 7 | 51 |
| Example 4 | S-4 | -- | 30 | 7 | 50 |
| Example 5 | S-5 | -- | 30 | 7 | 50 |
| Example 6 | S-6 | -- | 30 | 7 | 50 |
| Example 7 | S-7 | -- | 30 | 7 | 50 |
| Example 8 | S-8 | -- | 30 | 7 | 52 |
| Example 9 | S-9 | -- | 30 | 7 | 52 |
| Example 10 | S-10 | -- | 30 | 7 | 52 |
| Example 11 | S-11 | -- | 30 | 7 | 52 |
| Example 12 | S-12 | -- | 30 | 7 | 52 |
| Example 13 | S-13 | -- | 30 | 7 | 50 |
| Example 14 | S-14 | -- | 30 | 7 | 50 |

(continued)

| | Sulfonium Salt | Aid | On-press Development Property (sheets) | Printing Durability (10,000 sheets) | Tone Reproducibility (%) |
|---|---|---|---|---|---|
| Example 15 | S-15 | -- | 30 | 7 | 50 |
| Example 16 | S-16 | -- | 30 | 6 | 50 |
| Example 17 | S-17 | -- | 30 | 6 | 50 |
| Example 18 | S-18 | -- | 30 | 8 | 50 |
| Example 19 | S-19 | -- | 30 | 8 | 50 |
| Example 20 | S-20 | -- | 30 | 9 | 50 |
| Example 21 | S-21 | -- | 30 | 10 | 50 |
| Example 22 | S-22 | -- | 30 | 10 | 50 |
| Example 23 | S-23 | -- | 30 | 10 | 50 |
| Example 24 | S-24 | -- | 30 | 8 | 50 |
| Example 25 | S-25 | -- | 30 | 8 | 50 |
| Example 26 | S-26 | -- | 30 | 8 | 50 |
| Example 27 | S-27 | -- | 30 | 8 | 50 |
| Example 28 | S-28 | -- | 30 | 8 | 50 |
| Example 29 | S-29 | -- | 30 | 8 | 50 |
| Example 30 | S-30 | -- | 30 | 8 | 50 |
| Example 31 | S-31 | -- | 30 | 10 | 50 |
| Example 32 | S-22 | TPB | 30 | 12 | 50 |
| Example 33 | S-23 | TPB | 30 | 12 | 50 |
| Example 34 | S-28 | TPB | 30 | 10 | 50 |
| Example 35 | S-32 | -- | 30 | 7 | 52 |
| Example 36 | S-33 | -- | 30 | 8 | 50 |
| Example 37 | S-34 | -- | 30 | 6 | 51 |
| Example 38 | S-35 | -- | 30 | 7 | 52 |
| Example 39 | S-36 | -- | 30 | 6 | 51 |
| Comparative Example 1 | R-1 | -- | 30 | 7 | 60 |
| Comparative Example 2 | R-2 | -- | 30 | 4 | 50 |
| Comparative Example 3 | R-3 | -- | 30 | 7 | 60 |
| Comparative Example 4 | R-4 | -- | 30 | 4 | 50 |
| Comparative Example 5 | R-5 | -- | 30 | 4 | 50 |
| Comparative Example 6 | R-6 | -- | 30 | 7 | 60 |

(continued)

| | Sulfonium Salt | Aid | On-press Development Property (sheets) | Printing Durability (10,000 sheets) | Tone Reproducibility (%) |
|---|---|---|---|---|---|
| Comparative Example 7 | R-7 | -- | 30 | 4 | 50 |

It is apparent that the lithographic printing plate precursors according to the invention do not impair the on-press development property and provide lithographic printing plates achieving the compatibility between high printing durability and excellent tone reproducibility in comparison with the comparative examples. It is also apparent from the comparative examples that the compatibility between the printing durability and the tone reproducibility cannot be achieved in any of cases where only electron-withdrawing groups are substituted on a sulfonium salt, where one electron-withdrawing group substituted on a sulfonium salt, where although three electron-withdrawing groups are substituted on a sulfonium salt, a number of carbon atoms of a group substituted on an aryl group is too small or too large, and where a repeating unit number of an alkylene oxy group is too large.

2. Production of lithographic printing plate precursor of developer processing type (for Examples 40 to 78 and Comparative Examples 8 to 14)

A lithographic printing plate precursor was prepared in the same method as in Example 1 except for forming the undercoat layer and the image-recording layer as described below and changing the protective layer to a lower protective layer and an upper protective layer as described below.

<Formation of undercoat layer>

Coating solution (1) for undercoat layer shown below was coated on Support B described above by a wire bar and dried at 90°C for 30 seconds. The coating amount was 10 mg/m$^2$.

<Coating solution (1) for undercoat layer>

| | |
|---|---|
| Polymer compound A having structure shown below (Mw: 10,000) | 0.05 g |
| Methanol | 27 g |
| Ion-exchanged water | 3 g |

Polymer compound A

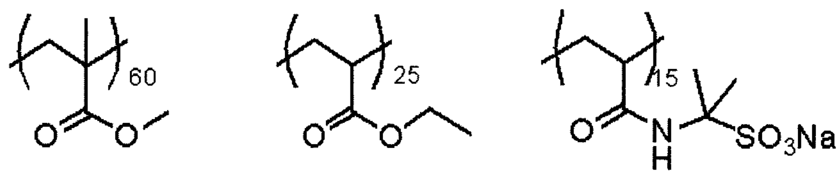

<Formation of image-recording layer>

Coating solution (2) for image-recording layer shown below was prepared and coated on the undercoat layer formed as described above using a wire bar to from an image-recording layer. The drying was conducted by a hot air drying device at 125°C for 34 seconds. The coverage after drying was 1.4 g/m$^2$.

<Coating solution (2) for image-recording layer>

| | |
|---|---|
| Infrared absorbing agent (IR-10) | 0.10 g |
| Sulfonium salt (compound shown in Table 2) | 0.30 g |
| Borate compound (TPB) | 0.06 g (in case of addition) |
| Pentaerythritol triacrylate hexamethylene diisocyanate urethane prepolymer (UA-306H, produced by Kyoeisha Chemical Co., Ltd.) | 1.33 g |
| Binder polymer (B) having structure shown below | 1.35 g |
| Ethyl violet | 0.04 g |
| Fluorine-based surfactant (MEGAFAC F-780-F, produced by DIC Corp., 30% by weight methyl isobutyl ketone (MIBK) solution) | 0.025 g |
| Methyl ethyl ketone | 18.4 g |
| Methanol | 9.83 g |
| 1-Methoxy-2-propanol | 18.4 g |

Binder polymer (B)

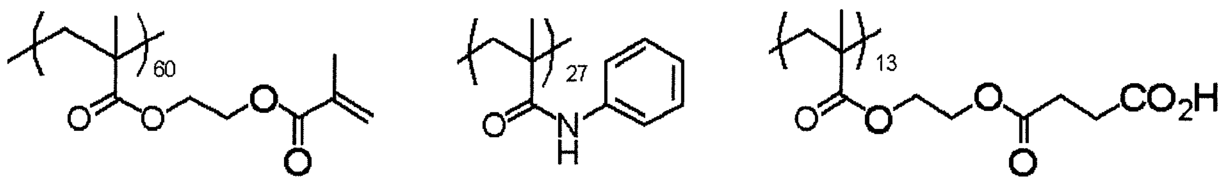

(Mw: 80,000)

[Formation of lower protective layer]

A mixed aqueous solution (coating solution for forming lower protective layer) composed of synthetic mica (SOMASIF MEB-3L, 3.2% by weight aqueous dispersion, produced by CO-OP Chemical Co., Ltd.), polyvinyl alcohol (GOSERAN CKS-50, saponification degree: 99% by mole, polymerization degree: 300, sulfonic acid-modified polyvinyl alcohol, produced by Nippon Synthetic Chemical Industry Co., Ltd.), Surfactant A (EMALEX 710, produced by Nihon Emulsion Co., Ltd.) and Surfactant B (ADEKA PLURONIC P-84, produced by ADEKA Corp.) was coated on the image-recording layer by a wire bar and dried by a hot air drying device at 125°C for 30 seconds.

The content ratio of synthetic mica (solid content)/polyvinyl alcohol/Surfactant A/Surfactant B in the coating solution for forming lower protective layer was 7.5/89/2/1.5 (in % by weight) and the coating amount (coverage after drying) was 0.5 g/m$^2$.

[Formation of upper protective layer]

A mixed aqueous solution (coating solution for forming upper protective layer) composed of organic filler (ART PEARL J-7P, produced by Negami Chemical Industrial Co., Ltd.), synthetic mica (SOMASIF MEB-3L, 3.2% aqueous dispersion, produced by CO-OP Chemical Co., Ltd.), polyvinyl alcohol (L-3266, saponification degree: 87% by mole, polymerization degree: 300, sulfonic acid-modified polyvinyl alcohol, produced by Nippon Synthetic Chemical Industry Co., Ltd.), thickener (CELLOGEN FS-B, produced by Dai-ichi Kogyo Seiyaku Co., Ltd.) and surfactant (EMALEX 710, produced by Nihon Emulsion Co., Ltd.) was coated on the lower protective layer by a wire bar and dried by a hot air drying device at 125°C for 30 seconds.

The content ratio of organic filler/synthetic mica (solid content)/polyvinyl alcohol/thickener/surfactant in the coating solution for forming upper protective layer was 3.2/2.0/80.5/11.5/2.8 (in % by weight) and the coating amount (coverage after drying) was 1.76 g/m$^2$.

[Plate making method]

The lithographic printing plate precursor obtained was processed according to the order of exposure, development processing and drying.

Light source (setter) used in the exposure: The imagewise exposure was conducted by an infrared semiconductor laser (TRENDSETTER 3244VX, produced by Creo Co., Ltd., equipped with a water-cooled 40 W infrared semiconductor laser) under the conditions of output of 9W, a rotational number of an external drum of 210 rpm and resolution of 2,400 dpi. As to the exposed image, as an image for evaluating reverse thin line, an image including reverse thin lines of from 5 to 100 μm width (at intervals of 5 μm) rowed was used. As an image for evaluating printing durability, an image capable of evaluating solid printing durability was used.

After the exposure, water washing processing was conducted in order to remove the protective layer, and the development processing was conducted using a solution prepared by diluting Developer HN-D (old product name: DH-N) produced by Fujifilm Corp. with water in a ratio of 1:4. The pH of the developer was 12. The temperature of the developing bath was 30°C.

The developer was supplied onto the surface of the lithographic printing plate precursor by showering from a spray pipe by a circulation pump. The tank volume of the developer was 10 liters. After the development, water washing processing was conducted in order to remove the developer attached on the surface of the lithographic printing plate precursor.

<Evaluation of lithographic printing plate precursor>

The lithographic printing plate precursor obtained was subjected to the plate making as described above, and the printing durability and the tone reproducibility were evaluated in the same manner as in the lithographic printing plate precursor of on-press development type. The results are shown in Table 2.

TABLE 2

| | Sulfonium Salt | Aid | Printing Durability (10,000 sheets) | Tone Reproducibility (%) |
|---|---|---|---|---|
| Example 40 | S-1 | -- | 9 | 51 |
| Example 41 | S-2 | -- | 9 | 51 |
| Example 42 | S-3 | -- | 9 | 51 |
| Example 43 | S-4 | -- | 9 | 50 |
| Example 44 | S-5 | -- | 9 | 50 |
| Example 45 | S-6 | -- | 9 | 50 |
| Example 46 | S-7 | -- | 9 | 50 |
| Example 47 | S-8 | -- | 9 | 52 |
| Example 48 | S-9 | -- | 9 | 52 |
| Example 49 | S-10 | -- | 9 | 52 |
| Example 50 | S-11 | -- | 9 | 52 |
| Example 51 | S-12 | -- | 9 | 52 |
| Example 52 | S-13 | -- | 9 | 50 |
| Example 53 | S-14 | -- | 9 | 50 |
| Example 54 | S-15 | -- | 9 | 50 |
| Example 55 | S-16 | -- | 8 | 50 |
| Example 56 | S-17 | -- | 8 | 50 |
| Example 57 | S-18 | -- | 10 | 50 |
| Example 58 | S-19 | -- | 10 | 50 |
| Example 59 | S-20 | -- | 11 | 50 |
| Example 60 | S-21 | -- | 12 | 50 |

(continued)

| | Sulfonium Salt | Aid | Printing Durability (10,000 sheets) | Tone Reproducibility (%) |
|---|---|---|---|---|
| Example 61 | S-22 | -- | 12 | 50 |
| Example 62 | S-23 | -- | 12 | 50 |
| Example 63 | S-24 | -- | 10 | 50 |
| Example 64 | S-25 | -- | 10 | 50 |
| Example 65 | S-26 | -- | 10 | 50 |
| Example 66 | S-27 | -- | 10 | 50 |
| Example 67 | S-28 | -- | 10 | 50 |
| Example 68 | S-29 | -- | 10 | 50 |
| Example 69 | S-30 | -- | 10 | 50 |
| Example 70 | S-31 | -- | 12 | 50 |
| Example 71 | S-22 | TPB | 14 | 50 |
| Example 72 | S-23 | TPB | 14 | 50 |
| Example 73 | S-28 | TPB | 12 | 50 |
| Example 74 | S-32 | -- | 9 | 52 |
| Example 75 | S-33 | -- | 10 | 50 |
| Example 76 | S-34 | -- | 8 | 51 |
| Example 77 | S-35 | -- | 9 | 52 |
| Example 78 | S-36 | -- | 8 | 51 |
| Comparative Example 8 | R-1 | -- | 9 | 60 |
| Comparative Example 9 | R-2 | -- | 5 | 50 |
| Comparative Example 10 | R-3 | -- | 9 | 60 |
| Comparative Example 11 | R-4 | -- | 5 | 50 |
| Comparative Example 12 | R-5 | -- | 5 | 50 |
| Comparative Example 13 | R-6 | -- | 9 | 60 |
| Comparative Example 14 | R-7 | -- | 5 | 50 |

It is apparent that the lithographic printing plate precursors according to the invention provide lithographic printing plates achieving the compatibility between high printing durability and excellent tone reproducibility in comparison with the comparative examples. It is also apparent from the comparative examples that the compatibility between the printing durability and the tone reproducibility cannot be achieved in any of cases where only electron-withdrawing groups are substituted on a sulfonium salt, where one electron-withdrawing group substituted on a sulfonium salt, where although three electron-withdrawing groups are substituted on a sulfonium salt, a number of carbon atoms of a group substituted on an aryl group is too small or too large, and where a repeating unit number of an alkylene oxy group is too large.

INDUSTRIAL APPLICABILITY

According to the invention, a lithographic printing plate precursor which is capable of being directly recorded from digital data, for example, of a computer, which has high sensitivity, which prevents an undesirable curing reaction in the non-image area from proceeding, and which provides high printing durability can be obtained.

**Claims**

1. A lithographic printing plate precursor comprising a support having provided thereon an image-recording layer containing (A) an infrared absorbing agent, (B) a sulfonium salt, (C) a polymerizable compound, and (D) a binder polymer, wherein the sulfonium salt (B) has a triarylsulfonium structure having three or more electron-withdrawing groups as substituents, and at least one aryl group constituting the triarylsulfonium structure has at least one of the electron-withdrawing groups and at least one group selected from the group consisting of a hydrocarbon group having from 4 to 12 carbon atoms, a group wherein a hydrocarbon group having from 4 to 12 carbon atoms is connected to an oxygen atom or a sulfur atom, and an ethylene oxide group having a repeating unit number of from 1 to 3.

2. The lithographic printing plate precursor as claimed in Claim 1, wherein the at least one aryl group constituting the triarylsulfonium structure of the sulfonium salt (B) has at least one of the electron-withdrawing groups and at least one group of a hydrocarbon group having from 4 to 12 carbon atoms and a group wherein a hydrocarbon group having from 4 to 12 carbon atoms is connected to an oxygen atom.

3. The lithographic printing plate precursor as claimed in Claim 2, wherein the electron-withdrawing group substituted on the aryl group together with the at least one group of a hydrocarbon group having from 4 to 12 carbon atoms and a group wherein a hydrocarbon group having from 4 to 12 carbon atoms is connected to an oxygen atom is a group selected from the group consisting of a chlorine atom, a fluorine atom and a trifluoromethyl group.

4. The lithographic printing plate precursor as claimed in any one of Claims 1 to 3, wherein the binder polymer (D) has an alkylene oxide group.

5. The lithographic printing plate precursor as claimed in any one of Claims 1 to 4, wherein the image-recording layer further contains a borate compound.

6. The lithographic printing plate precursor as claimed in Claim 5, wherein the borate compound is a tetraphenylborate salt.

7. The lithographic printing plate precursor as claimed in any one of Claims 1 to 6, which has a protective layer on the image-recording layer.

8. The lithographic printing plate precursor as claimed in Claim 7, wherein the protective layer contains an inorganic stratiform compound.

9. The lithographic printing plate precursor as claimed in any one of Claims 1 to 8, wherein the image-recording layer contains a binder polymer for on-press development and wherein an unexposed area of the image-recording layer is capable of being removed with at least one of dampening water and printing ink.

10. A plate making method comprising exposing imagewise the lithographic printing plate precursor of on-press development type as claimed in Claim 9 by an infrared laser, mounting the exposed lithographic printing plate precursor on a cylinder of printing machine, and removing the unexposed area of the image-recording layer with at least one of dampening water and printing ink.

**Patentansprüche**

1. Lithographiedruckplattenvorläufer, der einen Träger umfasst, auf dem eine Bildaufzeichnungsschicht bereitgestellt ist, die (A) einen Infrarotabsorber, (B) ein Sulfoniumsalz, (C) eine polymerisierbare Verbindung und (D) ein Bindemittelpolymer enthält,
worin das Sulfoniumsalz (B) eine Triarylsulfonium-Struktur mit drei oder mehr elektronenziehenden Gruppen als Substituenten hat und mindestens eine Arylgruppe hat, die die Triarylsulfonium-Struktur bildet und mindestens eine der elektronenziehenden Gruppen und mindestens eine Gruppe, ausgewählt aus einer Kohlenwasserstoffgruppe mit 4 bis 12 Kohlenstoffatomen, einer Gruppe, worin eine Kohlenwasserstoffgruppe mit 4 bis 12 Kohlenstoffatomen mit einem Sauerstoffatom oder einem Schwefelatom verbunden ist und einer Ethylenoxidgruppe mit einer Zahl an sich wiederholenden Einheiten von 1 bis 3, aufweist.

2. Lithographiedruckplattenvorläufer gemäß Anspruch 1,
worin die mindestens eine Arylgruppe, die die Triarylsulfonium-Struktur des Sulfoniumsalzes (B) bildet, mindestens eine der elektronenziehenden Gruppen, mindestens eine Gruppe einer Kohlenwasserstoffgruppe mit 4 bis 12 Kohlenstoffatomen und eine Gruppe, worin die Kohlenwasserstoffgruppe mit 4 bis 12 Kohlenstoffatomen mit einem Sauerstoffatom verbunden ist, aufweist.

3. Lithographiedruckplattenvorläufer gemäß Anspruch 2,
worin die an der Arylgruppe substituierte elektronenziehende Gruppe zusammen mit der mindestens einen Gruppe einer Kohlenwasserstoffgruppe mit 4 bis 12 Kohlenstoffatomen und einer Gruppe, worin die Kohlenwasserstoffgruppe mit 4 bis 12 Kohlenstoffatomen mit einem Sauerstoffatom verbunden ist, eine Gruppe ist, ausgewählt aus Chloratom, Fluoratom und einer Trifluormethylgruppe.

4. Lithographiedruckplattenvorläufer gemäß mindestens einem der Ansprüche 1-3, worin das Bindemittelpolymer (D) eine Alkylenoxidgruppe aufweist.

5. Lithographiedruckplattenvorläufer gemäß mindestens einem der Ansprüche 1-4, worin die Bildaufzeichnungsschicht ferner eine Boratverbindung enthält.

6. Lithographiedruckplattenvorläufer gemäß Anspruch 5, worin die Boratverbindung ein Tetraphenylboratsalz ist.

7. Lithographiedruckplattenvorläufer gemäß mindestens einem der Ansprüche 1-6, der eine Schutzschicht auf der Bildaufzeichnungsschicht hat.

8. Lithographiedruckplattenvorläufer gemäß Anspruch 7, worin die Schutzschicht eine anorganische, stratiforme Verbindung enthält.

9. Lithographiedruckplattenvorläufer gemäß mindestens einem der Ansprüche 1-8, worin die Bildaufzeichnungsschicht ein Bindemittelpolymer für das Entwickeln auf der Druckerpresse enthält und worin ein unbelichteter Bereich der Bildaufzeichnungsschicht dazu geeignet ist, mit zumindestens einem von Feuchtwasser und Druckerfarbe entfernt zu werden.

10. Verfahren zur Anfertigung von Platten, umfassend das bildweise Belichten des Lithographiedruckplattenvorläufers gemäß Anspruch 9 durch einen Infrarotlaser, Montieren des belichteten Lithographiedruckplattenvorläufers auf einem Zylinder der Druckmaschine und Entfernen der unbelichteten Bereiche der Bildaufzeichnungsschicht mit zumindest einem von Feuchtwasser und Druckerfarbe.

## Revendications

1. Précurseur de plaque d'impression lithographique comprenant un support sur lequel est disposée une couche d'enregistrement d'image contenant (A) un agent d'absorption d'infrarouge, (B) un sel de sulfonium, (C) un composé polymérisable, et (D) un polymère liant, dans lequel le sel de sulfonium (B) a une structure de triarylsulfonium ayant trois groupes électroattracteurs ou plus en tant que substituants, et au moins un groupe aryle constituant la structure de triarylsulfonium a au moins un des groupes électroattracteurs et au moins un groupe sélectionné dans le groupe constitué d'un groupe hydrocarboné ayant 4 à 12 atomes de carbone, un groupe dans lequel un groupe hydrocarboné ayant 4 à 12 atomes de carbone est relié à un atome d'oxygène ou à un atome de soufre, et un groupe oxyde d'éthylène ayant un nombre de motif répétitif allant de 1 à 3.

2. Précurseur de plaque d'impression lithographique selon la revendication 1, dans lequel le au moins un groupe aryle constituant la structure de triarylsulfonium du sel de sulfonium (B) a au moins un des groupes électroattracteurs et au moins un groupe parmi un groupe hydrocarboné ayant 4 à 12 atomes de carbone et un groupe dans lequel un groupe hydrocarboné ayant 4 à 12 atomes de carbone est relié à un atome d'oxygène.

3. Précurseur de plaque d'impression lithographique selon la revendication 2, dans lequel le groupe électroattracteur substitué sur le groupe aryle conjointement avec le au moins un groupe parmi un groupe hydrocarboné ayant 4 à 12 atomes de carbone et un groupe dans lequel un groupe hydrocarboné ayant 4 à 12 atomes de carbone est relié à un atome d'oxygène est un groupe sélectionné dans le groupe constitué d'un atome de chlore, d'un atome de fluor et d'un groupe trifluorométhyle.

**4.** Précurseur de plaque d'impression lithographique selon l'une quelconque des revendications 1 à 3, dans lequel le polymère liant (D) a un groupe oxyde d'alkylène.

**5.** Précurseur de plaque d'impression lithographique selon l'une quelconque des revendications 1 à 4, dans lequel la couche d'enregistrement d'image contient en outre un composé de borate.

**6.** Précurseur de plaque d'impression lithographique selon la revendication 5, dans lequel le composé de borate est un sel de tétraphénylborate.

**7.** Précurseur de plaque d'impression lithographique selon l'une quelconque des revendications 1 à 6, qui présente une couche protectrice sur la couche d'enregistrement d'image.

**8.** Précurseur de plaque d'impression lithographique selon la revendication 7, dans lequel la couche protectrice contient un composé inorganique stratiforme.

**9.** Précurseur de plaque d'impression lithographique selon l'une quelconque des revendications 1 à 8, dans lequel la couche d'enregistrement d'image contient un polymère liant pour un développement sur presse et dans lequel une zone non exposée de la couche d'enregistrement d'image est capable d'être éliminée avec au moins une parmi une eau de mouillage et une encre d'impression.

**10.** Procédé de fabrication d'une plaque comprenant une exposition à une image du précurseur de plaque d'impression lithographique de type à développement sur presse selon la revendication 9 par un laser infrarouge, un montage du précurseur de plaque d'impression lithographique exposé sur un cylindre d'une machine d'impression, et une élimination de la zone non exposée de la couche d'enregistrement d'image avec au moins une parmi une eau de mouillage et une encre d'impression.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5066564 A
- JP 8507727 A
- JP 10058636 A
- JP 2001096710 A
- US 5340699 A
- JP 7103171 B
- JP 2005067042 A
- JP 2009025837 A
- JP 2002107916 A
- JP 2003076010 A
- EP 1431032 A1
- JP 2001133969 A
- JP 2002023360 A
- JP 2002040638 A
- JP 2002278057 A
- JP 2008195018 A
- JP 2007090850 A
- JP 5005005 A
- JP 2001222101 A
- JP 4426795 B
- JP 8108621 A
- JP 61166544 A
- JP 2002328465 A
- JP 5158230 A
- US 4069055 A
- JP 4365049 A
- US 4069056 A
- EP 104143 A
- US 20080311520 A
- JP 2150848 A
- EP 370693 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2006508380 T
- JP 2002287344 A
- JP 2008256850 A
- JP 2001342222 A
- JP 9179296 A
- JP 9179297 A
- JP 9179298 A
- JP 2004294935 A
- JP 2006243493 A
- JP 2002275129 A
- JP 2003064130 A
- JP 2003280187 A
- JP 10333321 A
- JP 48041708 B
- JP 51037193 A
- JP 2032293 B
- JP 2016765 B
- JP 2003344997 A
- JP 2006065210 A
- JP 58049860 B
- JP 56017654 B
- JP 62039417 B
- JP 62039418 B
- JP 2000250211 A
- JP 2007094138 A
- US 7153632 B
- JP 8505958 T
- JP 2007293221 A
- JP 2007293223 A
- JP 2007249036 A
- JP 59044615 B
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A
- JP 11352691 A
- JP 2002040652 A
- JP 2005300650 A
- JP 2007248863 A
- JP 2007272134 A
- JP 2007017948 A
- JP 2003270775 A
- JP 7021633 B
- JP 9123387 A
- JP 9131850 A
- JP 9171249 A
- JP 9171250 A

- EP 931647 A
- JP 2001277740 A
- JP 2001277742 A
- EP 2383118 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 2006091479 A
- JP 10282679 A
- JP 2304441 A
- JP 2005238816 A
- JP 2005125749 A
- JP 2006239867 A
- JP 2006215263 A
- JP 2011245846 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A
- US 3458311 A
- JP 55049729 B
- JP 2005250216 A
- JP 2006259137 A
- JP 2012073597 A
- JP 2005119273 A
- JP 54012215 B
- WO 1303578 A


**Non-patent literature cited in the description**


- **SENRYO BINRAN.** *The Society of Synthetic Organic Chemistry,* 1970
- *J. Amer. Chem. Soc.,* 1990, vol. 112 (60), 6004-6015
- **S. I. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh, Proc. Conf. Rad. Curing ASIA,* October 1988, 478
- *Research Disclosure,* January 1992